# EUROPEAN PATENT APPLICATION

(11) **EP 1 377 145 A1**
(43) Date of publication of application: **02.01.2004**
(21) Application number: 02707177.8
(22) Date of filing: 27.03.2002
(51) Int. Cl.: H05K 3/46, H05K 1/11, H05K 3/40

(54) **MULTILAYER WIRING BOARD, METHOD FOR PRODUCING MULTILAYER WIRING BOARD, POLISHER FOR MULTILAYER WIRING BOARD, AND METAL SHEET FOR PRODUCING WIRING BOARD**

(30) Priority: 28.03.2001 JP 2001092698; 19.09.2001 JP 2001285175; 18.12.2001 JP 2001383887; 13.02.2002 JP 2002034798; 12.03.2002 JP 2002066410
(71) Applicant: North Corporation, Tokyo 170-0005 (JP)
(72) Inventor: IIJIMA, Tomoo, c/o NORTH CORPORATION, Tokyo 170-0005 (JP); KATO, Yoshiro, c/o NORTH CORPORATION, Tokyo 170-0005 (JP); ODAIRA, Hiroshi, c/o NORTH CORPORATION, Tokyo 170-0005 (JP); OHSAWA, Masayuki, c/o NORTH CORPORATION, Tokyo 170-0005 (JP); KUROSAWA, Inetaro, c/o NORTH CORPORATION, Tokyo 170-0005 (JP); SAKUMA, Kazuo, c/o NORTH CORPORATION, Tokyo 170-0005 (JP); ASANO, Toshihiko, c/o NORTH CORPORATION, Tokyo 170-0005 (JP); ENDO, Kimitaka, c/o NORTH CORPORATION, Tokyo 170-0005 (JP)
(74) Representative: VOSSIUS & PARTNER
(86) International application number: PCT/JP2002/002982
(87) International publication number: WO 2002/080639

(57) **Abstract**

A plurality of multi-layer metal plates (1) each being composed of a bump forming metal layer (2), an etching stop layer (3), and a wiring film forming metal layer (4), and in which a wiring film (4a) is formed from the wiring film forming metal layer and a bump 2a is formed from the bump forming metal layer are prepared, and on a bump forming surface of a multi-layer metal plate, a wiring film of another multi-layer metal plate is overlapped. Such lamination process is repeated in succession for multi-layering. In addition, a polishing machine for multi-layer wiring board (11a) which includes metal plate holding means (13) for holding a metal plate (1a), cutter holding means (25) for holding a cutter (26) above the metal plate, height adjustment mechanism (20) for adjusting the height of the cutter holding means, and cutter parallel moving mechanism (15) for relatively moving the cutter holding means in parallel to the surface of the metal plate is used to conduct polishing.

## Description

### TECHNICAL FIELD

The present invention relates to a method of manufacturing a multi-layer wiring board and a metal plate for forming the multi-layer wiring board, and more particularly to a multi-layer wiring board manufacturing method of manufacturing a high integration, high reliability wiring board having a microvia to a metal plate for forming a high integration, high reliability wiring board having a microvia.

### BACKGROUND ART

When high integration is to be obtained for a wiring board, it is required that the wiring board is multi-layered and connections between upper and lower wiring films are minutely formed with high reliability. The present invention responds to such requirement.

By the way, conventionally, there is a technique in which with respect to a multi-layer wiring board, for example, a wiring board in which wiring films are formed on both surfaces or in a multi-layer structure is used as a base (hereinafter referred to as "a core board" in some cases), an upper and lower wirings interconnecting hole is formed in the wiring board as the base by, for example, a drill or the like, a plating film is formed on the inner peripheral surface of the upper and lower wirings interconnecting hole to use the plating film as an upper and lower wirings interconnecting wiring film, a silver paste or an insulating paste is embedded in the upper and lower wirings interconnecting hole if necessary, copper foil having another interlayer connection bump on which an insulating resin is laminated, or copper foil coated with a resin is laminated on both surfaces of the wiring board as the base, it is drilled by using laser light, and a via is formed by a plating method. This is called a buildup method and is a multi-layer wiring board manufacturing method that was used as a method of increasing the integration of a board.

By the way, according to the above conventional high-density multi-layer wiring board manufacturing method, there is a problem that high integration is difficult to achieve. This is because it is difficult to reduce a size of the above upper and lower wirings interconnecting hole. When mass production and a yield are considered, it is difficult in practice to set the hole size to 0.3 mm or less in the core board and high integration is limited by the existence of the upper and lower wirings interconnecting hole having a relatively large hole size.

In other words, the upper and lower wirings interconnecting hole itself occupies a portion of the core board. Thus, when the hole size is large, this is a factor for directly limiting the integration of the wiring board. Further, the upper and lower wirings interconnecting hole constitutes a factor for forcing other wiring films to make a detour. Therefore, when the hole size is increased, this becomes a factor for increasing the number of wiring films that are forced to make a detour and also increasing the detour length of the detouring wiring film, and indirectly limits the integration of the wiring board.

Also, there were developed: a wiring board in which one main surface of a wiring board forming metal plate in which a plurality of metal bumps each having a longitudinal cross sectional shape such as a cone shape or a trapezoid shape are arranged in predetermined positions on the one main surface and which is made of metal foil is covered with at least an insulating sheet which is made of a synthetic resin and composed of an interlayer insulating film having a thickness smaller than the height of the metal bumps, so as to follow the shapes of the above respective metal bumps, and one main surface of the metal plate is polished so that a portion of the above insulating sheet which covers the metal bumps is removed to expose upper surfaces of the metal bumps; and the lamination manufacturing technique therefore, and the developed technique was proposed in JP 2000-334332 A. According to this, an insulating sheet (insulating layer) as an insulating layer of a wiring layer which is made of, for example, an epoxy resin, a polyimide resin, a polyester resin, a bismaleimide triazine resin, a polyphenylene ether resin, a liquid crystal polymer, or the like, and a peeling sheet (first peeling sheet) and a paper (second peeling sheet) which are made of a synthetic resin or metal foil are prepared, and are laminated on a bump formation side main surface of the above metal plate by a plate vacuum thermal press (thermal press). Thus, it is recognized that a polishing method allowing excellent mass production property and a polishing machine used for the polishing are required, and thus the polishing method and the polishing machine has been devised as the embodiments of the present invention. In other words, in a method of manufacturing a wiring board in which one main surface of a metal plate in which a plurality of metal bumps each having a longitudinal cross sectional shape such as a cone shape or a trapezoid shape are arranged in predetermined positions on the one main surface and which is made of metal foil is covered with an insulating sheet which is made of at least a synthetic resin and constitutes an interlayer insulating film having a thickness smaller than the height of the metal bumps, so as to follow the shapes of the above respective metal bumps, and one main surface of the metal plate is polished so that a portion of the above insulating sheet which covers the metal bumps is removed to expose upper surfaces of the metal bumps, improved mass production property of the polishing and a new wiring board polishing machine which is used for the polishing and capable of improving the mass production property of polishing are sought by the present invention.

Further, according to the metal plate, copper is used for a row material. Thus, electrical connections are provided through portions between the formed bumps and wiring films connected therewith by pressure welding of copper and a copper layer. However, with only pressure welding, electrical connection is not provided from the beginning, or even if the electrical connection is provided, by an accelerating test in which long-term usage is assumed, there is observed a phenomenon such that a pressure welding surface is deteriorated, or in some extreme cases, the electrical connection is lost.

The deterioration of the pressure-welding portion is related to the hardness of the bump. Specifically, copper oxide or other such coating film progresses due to a phenomenon in which a resin composing an insulating layer and other foreign matters such as, moisture, hydrogen, and the like gradually penetrate into the pressure welding portion, or the progress of oxidation on a pressure welding surface between the bump and the copper layer or the wiring film, so that a problem is cased in that an electrical resistance value between the bump and the copper layer or the wiring film is increased, thus reducing the long-term connection reliability. Basically, copper is very easy to oxidize and is a metal in which copper oxide is formed on its surface by the oxidation. Thus, when copper is used for electrical parts, for the stability of the surface, it is common to impart specific hardness to the surface or to perform predetermined processing in advance.

Therefore, an object of the present invention is to reduce an electrical resistance value between the bump provided on the copper layer and the wiring film made of copper foil or copper which is connected therewith, to thereby provide good electrical connection and also enhanced stability.

### DISCLOSURE OF THE INVENTION

According to a manufacturing method of the present invention, in order to provide an electrical connection between upper and lower wirings, a bump formed by patterning a bump forming metal layer of a multi-layer metal board is used as upper and lower wirings interconnecting means so that a conventional hole formation is unnecessary. Thus, as compared with a conventional case, the region of a portion required for interconnecting upper and lower wirings can be extremely narrowed such that a diameter thereof is for example 0.1 mm or less.

According to another manufacturing method of the present invention, a lamination process is repeated in succession for multi-layering in a manner such that, on a bump forming surface of a multi-layer metal plate, a wiring film forming surface of another multi-layer metal plate is overlapped. Thus, the number of layers of the multi-layer metal board can be arbitrarily increased according to the number of repetition of the process and a wiring board with very high integration can be provided.

According to further another manufacturing method of the present invention, in addition to the multi-layer wiring board manufacturing method in the preceding paragraph, the uppermost wiring film forming metal layer and the lowermost wiring film forming metal thin layer are simultaneously patterned. Thus, the number of wiring films can be further increased and an effect is also obtained in that the number of layers of the wiring board can be further increased.

According to further another manufacturing method of the present invention, in order to connect between upper and lower wirings, bumps formed by patterning a bump forming metal layer of a multi-metal layer board is used as upper and lower wirings interconnecting means so that a conventional hole formation is unnecessary. Thus, as compared with a conventional case, the region of a portion required for interconnecting upper and lower wirings can be extremely narrowed such that a diameter thereof is for example 0.1 mm or less.

According to further another manufacturing method of the present invention, a region of a portion required for interconnecting upper and lower wirings can be extremely narrowed such that a diameter thereof can be for example 0.1 mm or less. Thus, not only a direct effect is obtained with respect to the improvement of integration due to the narrowing of an area which an upper and lower wirings interconnecting portion itself occupies, but also the number of wiring films which are forced to make a detour can be reduced due to an indirect effect that adverse influence on other wiring films such that they are forced to make a detour is reduced. Further, another effect is obtained in that the detour length of the wiring films that are forced to make a detour can be also shortened.

According to further another manufacturing method of the present invention, a bump forming metal layer on which a wiring film forming metal layer is laminated through an etching stop layer is used as a base of a multi-metal layer, and the wiring film forming metal layer is patterned. Thus, a wiring film can be formed.

According to further another manufacturing method of the present invention, a bump forming metal layer on which an etching stop layer is laminated is used as a base of a multi-layer metal plate, and metal is selectively plated on an anti-bump forming metal layer side surface of the etching stop layer. Thus, a wiring film made from a plating film can be formed.

Then, since the wiring film is formed by plating, side etching that would be caused in the case where the wiring film forming metal layer is patterned by photo etching is not caused. Thus, minute wiring films can be formed at high integration.

According to further another manufacturing method of the present invention, a plural kinds of basic wiring boards with a multi-layer wiring structure are prepared and a plurality of basic wiring boards including different kinds of boards from among the plural kinds of basic wiring boards are laminated. As a result, a multi-layer wiring board with multi-layers, for example, 4 layers to 10 or more layers can be easily obtained.

According to further another manufacturing method of the present invention, after the plurality of basic wiring boards are laminated, wiring film forming metal layers as the uppermost layer and the lowermost layer are patterned. Thus, wiring films on the uppermost layer and the lowermost layer can be simultaneously formed, so that the number of wiring film forming steps can be reduced by one, and the cost of the multi-layer wiring board can be reduced.

According to further another manufacturing method of the present invention, a multi-layer metal plate, each layer of which is thin and its mechanical strength is low, is reinforced with a reinforcing layer. Thus, workability is improved and a fraction defective can be reduced. In addition, the surface of a wiring film forming metal layer is continuously protected by the reinforcing layer during a period from the first step to the wiring film patterning step. Thus, damage or the like to the surface in for example a press step is prevented and a defect is not caused in a formed wiring film. Further, the surface of the wiring film forming metal layer is protected from a chemical solution and deposition of contaminants on the surface is prevented.

According to further another manufacturing method of the present invention, the same effect as the multi-layer wiring board manufacturing method in the preceding paragraph or the paragraph prior to the preceding paragraph can be obtained. In addition, when a reinforcing layer is made of metal such as nickel or copper, etching is required for peeling it so that the number of steps is increased. However, in the case where the reinforcing layer is composed of a peeling layer and a heat resistant film as in this multi-layer wiring board manufacturing method, when a wiring film patterning step is to be conducted, it is sufficient that the heat resistant film is merely peeled off so that the process is simplified as a result.

According to a wiring board forming metal plate of the present invention, a multi-layer metal plate, each layer of which is thin and its mechanical strength is low, is reinforced with a reinforcing layer. Thus, workability is improved and a fraction defective can be reduced. In addition, the surface of a wiring film forming metal layer is continuously protected by a heat resistant film during a period of from the first step to the wiring film patterning step. Thus, damage or the like to the surface in, for example, a press step is prevented and a defect is not caused in a formed wiring film. Further, the surface of the wiring film forming metal layer is protected from a chemical solution and deposition of contaminants on the surface is prevented. Furthermore, when the reinforcing layer is made of metal such as nickel or copper, etching is required for peeling it so that the number of steps is increased. However, in the case where the metal plate for wiring board formation is composed of a peeling layer and a heat resistant film, when a wiring film patterning step is to be conducted, it is sufficient that the heat resistant film is merely peeled off so that the process is simplified as a result.

According to further another multi-layer board manufacturing method of the present invention, in a method of manufacturing a multi-layer wiring board, in which on one main surface of a metal board for forming a wiring board, a plurality of metal bumps having a longitudinal cross sectional shape such as a cone shape or a trapezoid shape are arranged in predetermined positions, covered with at least an insulating sheet which is made of a synthetic resin and composed of an interlayer insulating film having a thickness smaller than the height of the bumps, so as to follow the shapes of the above respective metal bumps, and the one main surface of the above metal plate is polished so that a portion of the above insulating sheet which covers the bumps is removed to expose upper surfaces of the bumps, the polishing is conducted as follows, the above metal plate is placed such that the one main surface faces upward, a cutter having a large width is moved relatively to the above metal plate in parallel to the main surface and the top surfaces of the respective bumps are cut by the cutter such that they lie on the same plane as the surface of the insulating sheet.

According to another multi-layer board manufacturing method of the present invention, the cutter having a large width in the preceding paragraph is moved in a direction parallel to the metal plate while applying low frequency vibration or ultrasonic vibration in a direction perpendicular to the main surface.

According to further another multi-layer board manufacturing method of the present invention, the invention includes at least metal plate holding means for holding the metal plate with a state in which the one main surface faces upward, cutter holding means for holding a cutter above the metal plate, height adjustment mechanism for adjusting the height of the cutter holding means relative to the metal plate, and cutter parallel moving mechanism for relatively moving the cutter holding means in parallel to the surface of the metal plate.

According to further another manufacturing method of the present invention, in the multi-layer board manufacturing method in the paragraph prior to the preceding paragraph, the invention is characterized in that polishing which is conducted by passing a metal plate between a polishing roller or a buff roller and a backup roller is conducted plural times such that the degree of finish is gradually increased.

According to further another multi-layer wiring board manufacturing method of the present invention, the polishing is conducted in such a manner that a cutter roller, in which cutters each having a large width are provided on its peripheral surface such that cutting edges thereof protrude toward the rotation direction side, is rotated, and then the top surfaces of the respective bumps are cut by the cutters of the rotated cutter roller such that they lie on the same plane as the surface of the insulating sheet.

According to a multi-layer wiring board manufacturing method of the present invention, a polishing machine of the invention is characterized by including at least a polishing roller or a buff roller in which a polishing material is sintered on its peripheral surface, roller rotating means for rotating the polishing roller or the buff roller, a backup roller, pressing means for pressing the backup roller to the polishing roller or the buff roller, and carrying means for carrying a metal plate between the polishing roller or the buff roller and the backup roller.

According to a multi-layer wiring board manufacturing method of the present invention, a polishing machine of the invention has a plurality of metal plate polishing portions each including at least: a polishing roller or a buff roller in which a polishing material is sintered on its peripheral surface; roller rotating means for rotating the polishing roller or the buff roller; a backup roller; pressing means for pressing the backup roller to the polishing roller or the buff roller; and carrying means for carrying a metal plate between the polishing roller or the buff roller and the backup roller. The roughnesses of the polishing materials of the polishing rollers or the roughnesses of the surfaces of the buff rollers in the above respective metal plate polishing portions are made different from each other.

According to further another multi-layer wiring board manufacturing method of the present invention, a polishing machine of the invention is characterized by including at least metal plate holding means for holding the metal plate with a state in which the one main surface faces upward, cutter roller holding means for rotatably holding a cutter roller over the metal plate, rotation drive means for rotating the cutter roller, height adjustment mechanism for adjusting the height of the cutter roller holding means relative to the metal plate, and cutter roller parallel moving mechanism for relatively moving the cutter roller holding means in parallel to the surface of the metal plate.

According to further another multi-layer wiring board manufacturing method of the present invention, Vickers hardnesses of a bump made of metal (copper) and a metal layer (copper layer) which is laminated thereon and connected therewith is set to 80 to 150 Hv.

According to further another multi-layer wiring board manufacturing method of the present invention, before lamination, blackening reduction processing is performed for one or both of a top surface of a bump of a metal member and a surface of a metal layer (copper layer) to be laminated on the metal member or a surface of a metal layer (copper layer) which becomes a wiring film or a wiring film of another wiring circuit forming board.

According to further another multi-layer wiring board manufacturing method of the present invention, when, on a wiring forming board in which upper and lower wirings interconnecting bumps made of metal are integrally formed on a metal (copper) layer, an interlayer insulating layer is to be formed in a portion of the metal (copper) layer in which the bumps are not formed, bump holes engaging with the respective bumps are provided in a portion corresponding to the upper and lower wirings interconnecting bumps. Then, the interlayer insulating film is overlapped on the metal (copper) layer in a state in which the respective bump holes are engaged with the corresponding respective upper and lower wirings interconnecting bumps. Further, a wiring forming metal (copper) layer is pressurized onto the interlayer insulating film.

According to further another multi-layer wiring board manufacturing method of the present invention, in the multi-layer wiring board manufacturing method in the preceding paragraph, the formation of the above respective bump holes in the above interlayer insulating film is performed as follows. The interlayer insulating layer is made to abut with a bump forming surface of a wiring circuit forming board in which upper and lower wirings interconnecting bumps are formed so that the interlayer insulating layer is penetrated by the upper and lower wirings interconnecting bumps.

According to further another multi-layer wiring board manufacturing method of the present invention, in the multi-layer wiring board manufacturing method in the paragraph prior to the preceding paragraph, the formation of the above respective bump holes in the above interlayer insulating film is performed as follows. The interlayer insulating layer is selectively penetrated by laser light irradiation using as a mask a mask body having substantially the same pattern as the upper and lower wirings interconnecting bumps of the wiring forming board.

According to a multi-layer metal plate for a multi-layer wiring board manufacturing method of the present invention, on an interlayer insulating layer and upper surfaces of bumps of a board in which the upper and lower wirings interconnecting bumps made of metal are integrally formed on a metal (copper) layer and the interlayer insulating layer is formed in a portion in which the bumps are not formed on the metal (copper) layer, a multi-layer metal plate in which extension bumps are formed in positions corresponding to the respective upper and lower wirings interconnecting bumps is laminated such that the respective bumps are electrically connected with the respective upper and lower wirings interconnecting bumps corresponding thereto, and an interlayer insulating layer is formed in a portion of the metal plate in which the extension bumps are not formed.

According to a multi-layer wiring board manufacturing method of the present invention, the method includes: a step of laminating a metal plate on an interlayer insulating layer and upper surfaces of upper and lower wirings interconnecting bumps of a board in which the upper and lower wirings interconnecting bumps made of metal (copper) are integrally formed on a metal (copper) layer and the interlayer insulating layer is formed in a portion in which the bumps are not formed on the metal (copper) layer; a step of selectively etching the metal plate to form extension bumps connected with the respective upper and lower wirings interconnecting bumps in positions corresponding thereto; and a step of forming an interlayer insulating layer in a portion of the metal plate in which the extension bumps are not formed.

According to a multi-layer wiring circuit forming board of the present invention, in a manufacturing method for a multi-layer wiring circuit forming board in which a metal (copper) layer or another wiring circuit forming board is laminated on an interlayer insulating layer and upper surfaces of bumps of a wiring circuit forming board in which the upper and lower wirings interconnecting bumps made of metal (copper) are integrally formed on a metal (copper) layer and the interlayer insulating layer is formed in a portion in which the bumps are not formed on the metal (copper) layer, the wiring circuit forming board in which the upper and lower wirings interconnecting bumps made of metal (copper) are integrally formed on the metal (copper) layer and the interlayer insulating layer is formed by laminating an insulating sheet composing the interlayer insulating layer on a surface of the metal (copper) layer on which the upper and lower wirings interconnecting bumps are formed is polished by being passed between the polishing roller and the backup roller before the metal (copper) layer or another wiring circuit forming board is laminated.

### BRIEF DESCRIPTION OF THE DRAWINGS

Figs. 1(A) to 1(D) are sectional views showing in order steps shown in Figs. 1(A) to 1(D), of steps shown in Figs. 1(A) to 3(K) in a first embodiment mode of a multi-layer wiring board manufacturing method according to the present invention.

Figs. 2(E) to 2(H) are sectional views showing in order steps shown in Figs. 2(E) to 2(H), of the steps shown in Figs. 1(A) to 3(K) in the first embodiment mode of the multi-layer wiring board manufacturing method according to the present invention.

Figs. 3(I) to 3(K) are sectional views showing in order steps shown in Figs. 3(I) to 3(K), of the steps shown in Figs. 1(A) to 3(K) in the first embodiment mode of the multi-layer wiring board manufacturing method according to the present invention

Figs. 4(A) to 4(D) are sectional views showing in step order of a method of manufacturing an example of a basic wiring board used for a second embodiment mode of a multi-layer wiring board manufacturing method according to the present invention.

Fig. 5 is a sectional view showing another example of a basic wiring board used for the second embodiment mode of the multi-layer wiring board manufacturing method according to the present invention.

Fig. 6 is a sectional view showing further another example of a basic wiring board used for the second embodiment mode of the multi-layer wiring board manufacturing method according to the present invention.

Fig. 7 is a sectional view showing further another example of a basic wiring board used for the second embodiment mode of the multi-layer wiring board manufacturing method according to the present invention.

Figs. 8(A) and 8(B) are explanatory views of an example of a multi-layer wiring board with 4 layers, in which Fig. 8(A) shows 2 basic wiring boards composing the multi-layer wiring board and Fig. 8(B) shows a state in which the 2 basic wiring boards are laminated.

Figs. 9(A) and 9(B) are explanatory views of an example of a multi-layer wiring board with 6 layers, in which Fig. 9(A) shows 3 basic wiring boards composing the multi-layer wiring board and Fig. 9(B) shows a state in which the 3 basic wiring boards are laminated.

Figs. 10(A) and 10(B) are explanatory views of an example of a multi-layer wiring board with 8 layers, in which Fig. 10(A) shows 4 basic wiring boards composing the multi-layer wiring board and Fig. 10(B) shows a state in which the 4 basic wiring boards are laminated.

Figs. 11(A) and 11(B) are explanatory views of an example of a multi-layer wiring board with 10 layers, in which Fig. 11 (A) shows 5 basic wiring boards composing the multi-layer wiring board and Fig. 11(B) shows a state in which the 5 basic wiring boards are laminated.

Figs. 12(A) to 12(E) are sectional views showing in order steps shown in Figs. 12(A) to 12(E), of steps shown in Figs. 12(A) to 13(I) in a third embodiment mode of a multi-layer wiring board manufacturing method according to the present invention.

Figs. 13(F) to 13(I) are sectional views showing in order steps shown in Figs. 13(F) to 13(I), of steps shown in Figs. 12(A) to 13(I) in the third embodiment mode of the multi-layer wiring board manufacturing method according to the present invention.

Figs. 14(A) and 14(B) are sectional views showing in order steps shown in Figs. 14(A) and 14(B) in a modified example of the above third embodiment mode.

Figs. 15(A) to 15(E) are sectional views showing in order steps shown in Figs. 15(A) to 15(E) in a fourth embodiment mode of a multi-layer wiring board manufacturing method according to the present invention.

Figs. 16(A) to 16(E) are sectional views showing in order steps shown in Figs. 16(A) to 16(E) in a fifth embodiment mode of a multi-layer wiring board manufacturing method according to the present invention.

Fig. 17 is a side view of a metal plate polishing machine for use of a sixth embodiment mode of a multi-layer wiring board manufacturing method according to the present invention.

Fig. 18 is a side view of a metal plate polishing machine for use of a seventh embodiment mode of a multi-layer wiring board manufacturing method according to the present invention.

Figs. 19(A) and 19(B) is a side view of a metal plate polishing machine for use of an eighth embodiment mode of a multi-layer wiring board manufacturing method according to the present invention, in which Fig. 19(A) is a perspective view and Fig. 19(B) is a side view showing a state in which a main surface of a metal plate is polished by a cutter roller.

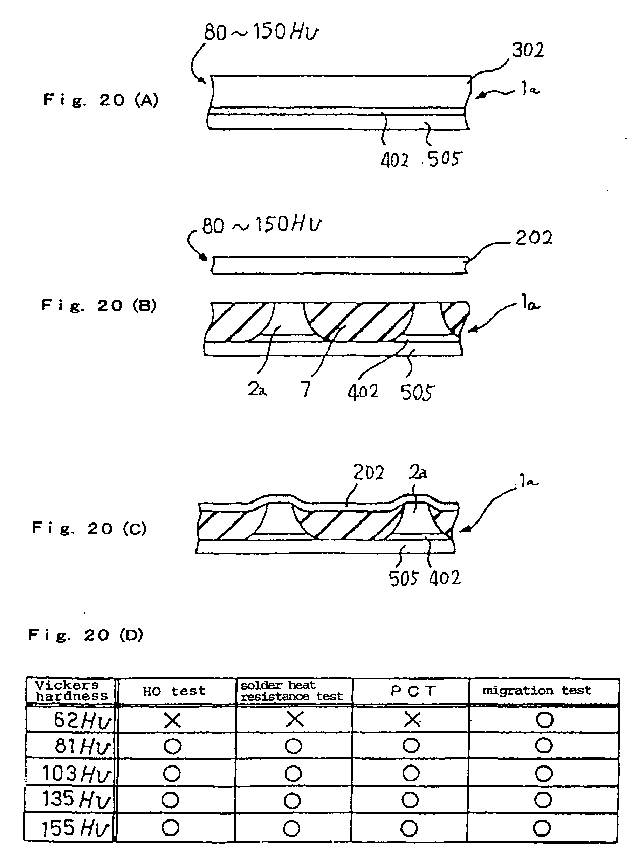

Figs. 20(A) to 20(D) are explanatory views of a ninth embodiment mode of a multi-layer wiring board manufacturing method according to the present invention, in which Fig. 20(A) is a sectional view of a metal (copper) plate 1a containing mainly metal (copper), Fig. 20(B) is a sectional view of a processed metal (copper) plate 1a and a metal layer (copper layer) 202 bonded thereto, Fig. 20(C) is a sectional view showing a state in which the metal layer 202 is welded with pressure to bumps, and Fig. 20(D) is a table indicating a reason why Vickers hardness of a metal (copper) portion of a multi-layer wiring circuit board forming member is set to 80 to 150 Hv.

Figs. 21(A) to 21(E) show a tenth embodiment mode of a multi-layer wiring board manufacturing method according to the present invention, in which Figs. 21(A) to 21(D) are sectional views showing the manufacturing method in step order, and Fig. 21(E) shows by way of a table the states of a bump forming member side and a metal (copper) layer laminated thereon as to whether they are good or poor, with regard to various processing contents.

Figs. 22 (A) to 22 (C) are sectional views showing in step order an eleventh embodiment mode of a multi-layer wiring board manufacturing method according to the present invention.

Figs. 23(1) to 23(7) are sectional views showing in step order a twelfth embodiment mode of a multi-layer wiring board manufacturing method according to the present invention and Figs. 23(11) to 23(15) are sectional views showing in step order a modified example of the embodiment mode.

Figs. 24(1) to 24(5) are sectional views showing in step order a thirteenth embodiment mode of a multi-layer wiring board manufacturing method according to the present invention.

Fig. 25 is a sectional view showing a fourteenth embodiment mode of a multi-layer wiring board manufacturing method according to the present invention.

### BEST MODE FOR CARRYING OUT THE INVENTION

Hereinafter, the present invention will be described in detail according to embodiment modes thereof.

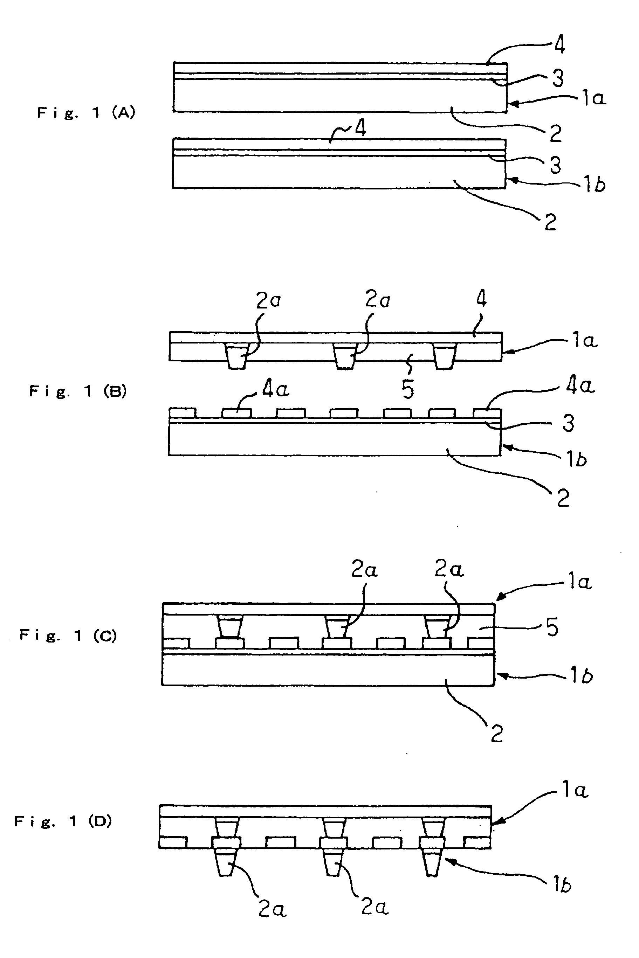

Figs. 1(A) to 1(D), Figs. 2 (E) to 2(H), and Figs. 3(I) to 3(K) are sectional views showing steps of Figs. 1(A) to 3(K) in order in a first embodiment mode of a multi-layer wiring board manufacturing method according to the present invention.

(A) First, as shown in Fig. 1(A), multi-layer metal plates 1a and 1b are prepared. Note that the multi-layer metal plate 1a corresponds to a first multi-layer metal plate in claim 1 and the multi-layer metal plate 1b corresponds to a second multi-layer metal plate of claim 1.

The above multi-layer metal plates 1a and 1b each are obtained by laminating a wiring film forming metal layer 4 made of copper foil having a thickness of for example 18 µm on one main surface of a bump forming metal layer 2 made of copper foil having a thickness of for example 100 µm, through an etching stop layer 3 made of a nickel layer having a thickness of for example 2 µm.

(B) Next, with respect to the above multi-layer metal plate 1a, the bump forming metal layer 2 and the etching stop layer 3 are patterned by selective etching to form bumps 2a for interconnecting upper and lower wirings. In this selective etching, the etching stop layer 3 prevents wiring films 4a from being etched at the time of etching the bump forming metal layer 2. Then, when the selective etching of the bump forming metal layer 2 is completed, etching is conducted for the etching stop layer 3 using as a mask copper that is a material which forms the bump forming metal layer 2 and the wiring film forming metal layer 4.

After that, an insulating film 5 made of for example a resin is bonded onto a forming surface of the above bumps 2a so as to expose only the top portions of the bumps 2a from the surface of the film 5.

On the other hand, with respect to the above multi-layer metal plate 1b, the wiring film forming metal layer 4 is patterned to form wiring films 4a. At this time, the etching stop layer 3 prevents etching of the bump forming metal layer 2. Fig. B) shows the multi-layer metal plate 1b in which the formation of the wiring films 4a is completed and the multi-layer metal plate 1a in which the formation of the insulating film 5 is completed.

Note that, hereinafter, the wiring films 4a and the bumps 2a of the multi-layer metal plate 1 are also formed by the above method.

(C) Next, the bumps 2a of the multi-layer metal plate 1a are connected with the wiring films 4a of the multi-layer metal plate 1b and the multi-layer metal plates 1a and 1b are laminated. Fig. 1(C) shows a state after the lamination.

(D) Next, the bump forming metal layer 2 and the etching stop layer 3 of the above multi-layer metal plate 1b are patterned by selective etching to form bumps 2a. Fig. 1(D) shows a state after the formation of the bumps 2a.

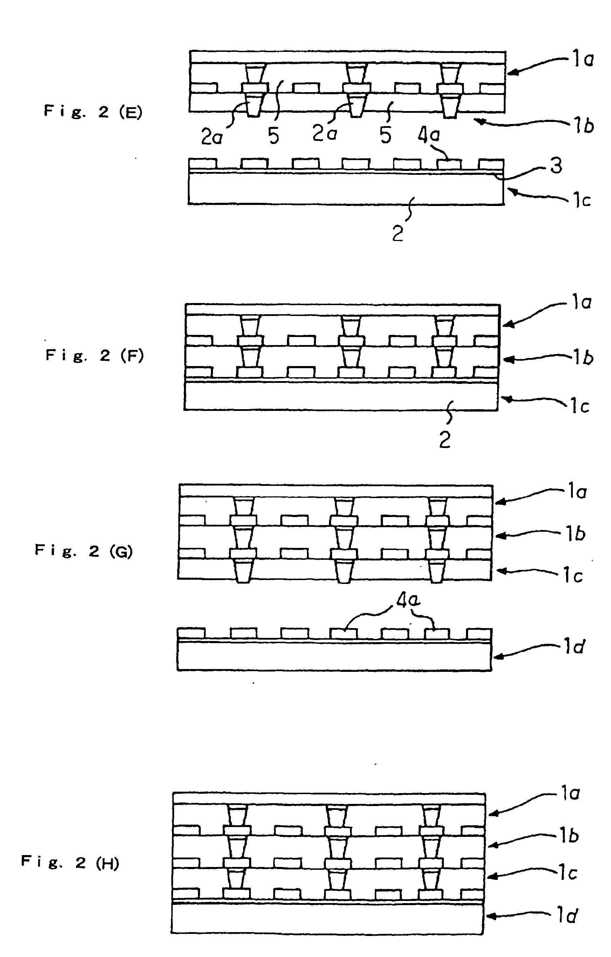

(E) Next, an insulating film 5 made of for example a resin is bonded onto a surface for forming the above bumps 2a so as to expose only the top portions of the bumps 2a from the surface of the insulating film 5. Then, a multi-layer metal plate 1c is prepared as a new multi-layer metal plate. With respect to the multi-layer metal plate 1c, a wiring film forming metal layer 4 of the multi-layer metal plate 1 having the same structure as the multi-layer metal plates 1a and 1b each having a three layers structure shown in Fig. 1(A) is patterned by selective etching to form wiring films 4a. Fig. 2(E) shows a state in which a bump 2a forming side surface of a laminate of the multi-layer metal plates 1a and 1b faces a wiring film 4a forming side surface of the multi-layer metal plate 1c in which the formation of the wiring films 4a is completed.

(F) Next, as shown in Fig. 2(F), the bumps 2a of the multi-layer metal plate 1a are connected with the wiring films 4a of the multi-layer metal plate 1b and the multi-layer metal plate 1c is laminated onto the multi-layer metal plate 1b.

(G) Next, the bump forming metal layer 2 and the etching stop layer 3 of the multi-layer metal plate 1b are patterned by selective etching to form bumps 2a. Then, an insulating film 5 made of for example a resin is bonded onto a forming surface of the bumps 2a so as to expose only the top portions of the bumps 2a from the film 5.

Then, a multi-layer metal plate 1d is prepared as a new multi-layer metal plate. With respect to the multi-layer metal plate 1d, a wiring film forming metal layer 4 of the multi-layer metal plate having the same structure as the multi-layer metal plates 1a, 1b and 1c each having a three layers structure shown in Fig. 1(A) is patterned by selective etching to form wiring films 4a. Fig. 2(G) shows a state in which a bump 2a forming side surface of a laminate of the multi-layer metal plates 1a, 1b and 1c after the formation of the insulating film 5 faces a wiring film 4a forming side surface of the new multi-layer metal plate 1d.

(H) Next, as shown in Fig. 2(H), the bumps 2a of the multi-layer metal plate 1b are connected with the wiring films 4a of the multi-layer metal plate 1c and the multi-layer metal plate 1d is laminated to the laminate of the multi-layer metal plates 1a, 1b and 1c.

(I) Next, a bump forming metal layer 2 and an etching stop layer 3 of a multi-layer metal plate 1d are patterned by selective etching to form bumps 2a. After that, an insulating film 5 made of for example a resin is bonded onto a surface for forming the bumps 2a such that it is broken through by the bumps 2a so that the top portions of the bumps protrude therefrom.

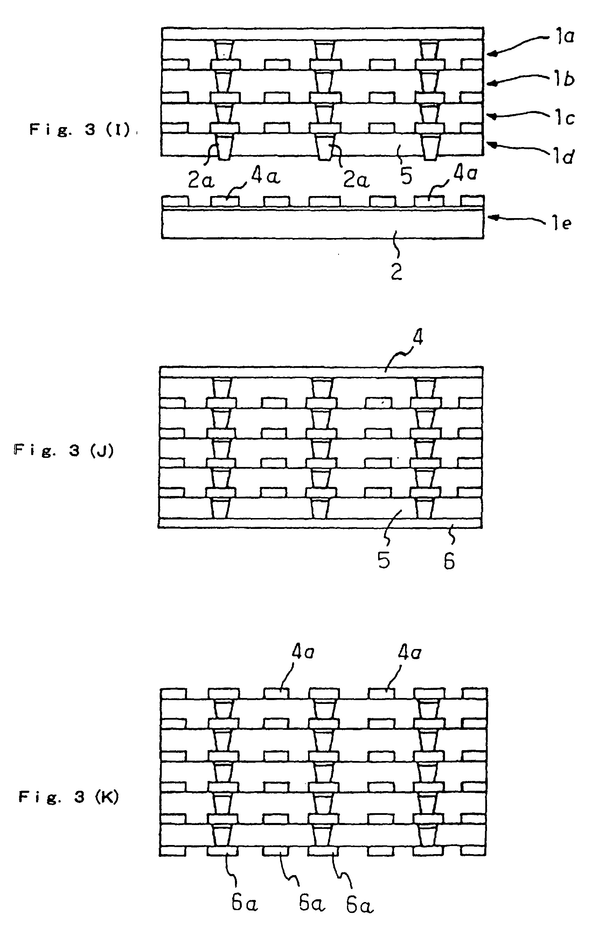

After that, a multi-layer metal plate 1e is prepared as a new multi-layer metal plate. With respect to the multi-layer metal plate 1e, a wiring film forming metal layer 4 of a multi-layer metal plate having the same structure as the multi-layer metal plates 1a and 1b each having a three layers structure shown in Fig. 1(A) is patterned by selective etching to form wiring films 4a. Fig. 3(I) shows a state in which a bump 2a forming side surface of a laminate of the multi-layer metal plates 1a to 1d obtained after the formation of the insulating film 5 faces a wiring film 4a forming surface of the new multi-layer metal plate 1e.

(J) Next, the bump forming metal layer 2 and the etching stop layer 3 of the above multi-layer metal plate 1e are patterned by selective etching to form bumps 2a. Then, an insulating film 5 made of for example a resin is bonded onto its bumps 2a forming surface so as to expose only the top portions of the bumps 2a from the surface of the film 5. After that, a wiring film forming metal thin plate 6 made of copper is connected with the bumps 2 and laminated onto the bump 2a forming surface side. Fig. 3(J) shows a state after the lamination.

(K) Next, the wiring film forming metal layer 4 of the above multi-layer metal plate 1a (the uppermost multi-layer metal plate in Figs. 1 to 3) and the above wiring film forming metal thin plate 6 are patterned by selective etching to form wiring films 4a and 6a. Then, the wiring films 4a become the uppermost layer wiring films and the wiring films 6a become the lowermost layer wiring films.

Summarizing this multi-layer wiring board manufacturing method, the multi-layer metal plate 1a is used as a base, the bump forming metal layer 2 and the etching stop layer 3 thereof are patterned to form the bumps 2a, the insulating film 5 is bonded onto the bump 2a forming surface such that it is broken through by the bumps 2a so as to cause the top portions thereof to protrude from the surface of the insulating film 5, and then the wiring films 4a of another multi-layer metal plate 1b in which the wiring films 4a are formed by patterning the wiring film forming metal layer 4 are connected with the bumps 2a of the multi-layer metal plate 1a, and the multi-layer metal plates 1a and 1b are laminated. Such a lamination process is repeated for multi-layering in a manner such that the wiring film 6a forming surface of another multi-layer metal plate 1 is always overlapped on the bumps 2a forming surface of another multi-layer metal plate 1. Finally, the wiring film forming metal layer 4 and the wiring film forming metal thin plate 6 which are located on the uppermost surface and the lowermost surface, respectively, are patterned to form the wiring films 4a and the wiring films 6a which are located on the uppermost surface and the lowermost surface, respectively. Thus, by increasing the number of repetitions of the above lamination process, the number of layers of the wiring board can be increased.

According to this multi-layer wiring board manufacturing method, with respect to interconnection between upper and lower wirings, the conventional technique, in which the hole is formed in the insulating plate as a base, the metal plating film for interconnecting upper and lower wirings is formed on the inner peripheral surface thereof, and then the hole is filled, is not followed, but the bumps 2a formed by patterning the bump forming metal layer 2 of the multi-layer metal wiring 1 are used as upper and lower wirings interconnecting means. Thus, as compared with a conventional case, the region of a portion required for interconnecting upper and lower wirings can be extremely narrowed such that a diameter thereof is for example 0.1 mm or less.

When the upper and lower wirings interconnecting portion can be narrowed, not only a direct effect is produced with respect to improvement of integration due to the narrowing of an area which itself occupies but also an indirect effect is produced in that adverse influence on other wiring films such that the number of them to be forced to make a detour is reduced. In other words, due to the indirect effect that adverse influence on other wiring films is reduced, the number of wiring films which are forced to make a detour can be reduced and the detour length of the wiring film which is forced to make a detour can be also shortened. Thus, the integration can be markedly improved.

Also, the lamination process is repeated for multi-layering in succession in a manner such that the wiring film 4a forming surface of one multi-layer metal plate 1 is always overlapped on the bumps 2a forming surface of another multi-layer metal plate 1. Thus, according to the number of repetition processes, the number of layers of the multi-layer metal plates can be arbitrarily increased so that a wiring board with a very high integration can be provided.

Note that the respective wiring boards 1a, 1b, 1c, ... may be laminated after the formation of the wiring films 4a and the bumps 2a and bonding of the insulating film 5.

Note that, according to the above first embodiment mode, a laminate obtained by laminating the wiring film forming metal layer 4 on the bump forming metal layer 2 through the etching stop layer 3 is prepared as a base and the wiring film forming metal layer 4 is selectively etched for patterning to form the wiring films 4a of the multi-layer metal plate 1a, 1b, or the like. The wiring films 4a can be also formed by plating. When the wiring films 4a are formed by plating, side etching caused in the case where the wiring film forming metal layer 4 is patterned by photo etching is not occurred. Thus, minute wiring films 4a can be formed at high integration.

Specifically, a method of preparing a laminate obtained by laminating the etching stop layer 3 on the bump forming metal layer 2 as a base, selectively forming for example a photo resist film on an anti-bump forming metal layer side surface of the etching stop layer 3, and plating for example metal such as copper using the photo resist film as a mask to form the wiring films 4a is preferable. In addition, the wiring films may be directly formed on the surface of the etching stop layer 3 by plating. Alternatively, a thin plating base layer made of for example copper may be formed on the surface of the etching stop layer and the wiring films 4a may be formed on the plating base layer by plating using the photo resist film as a mask. In this case, it is necessary to etch the thin plating base layer using the wiring films 4a as a mask after the formation of the wiring films 4a.

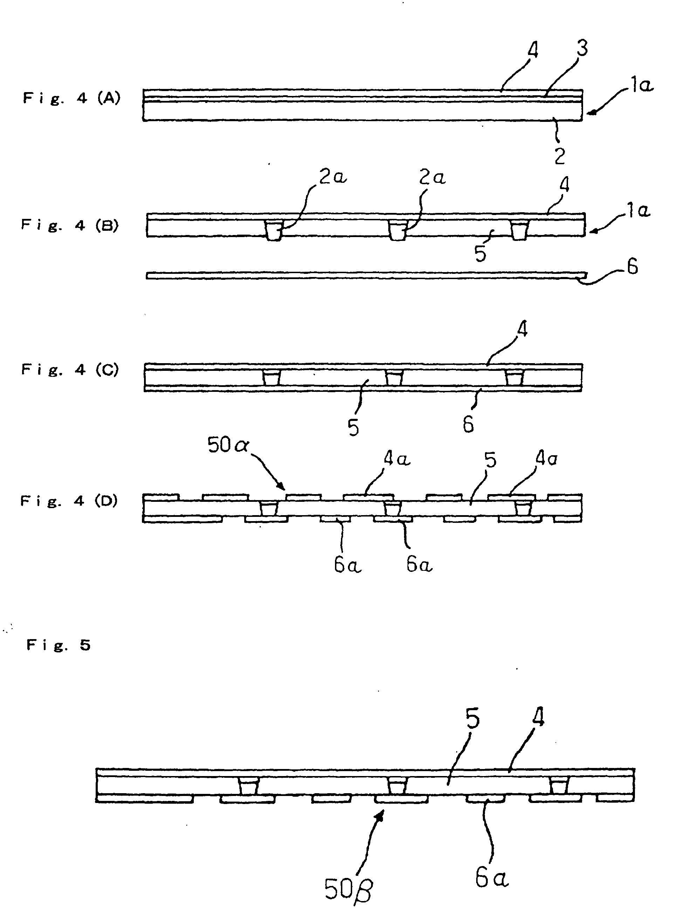

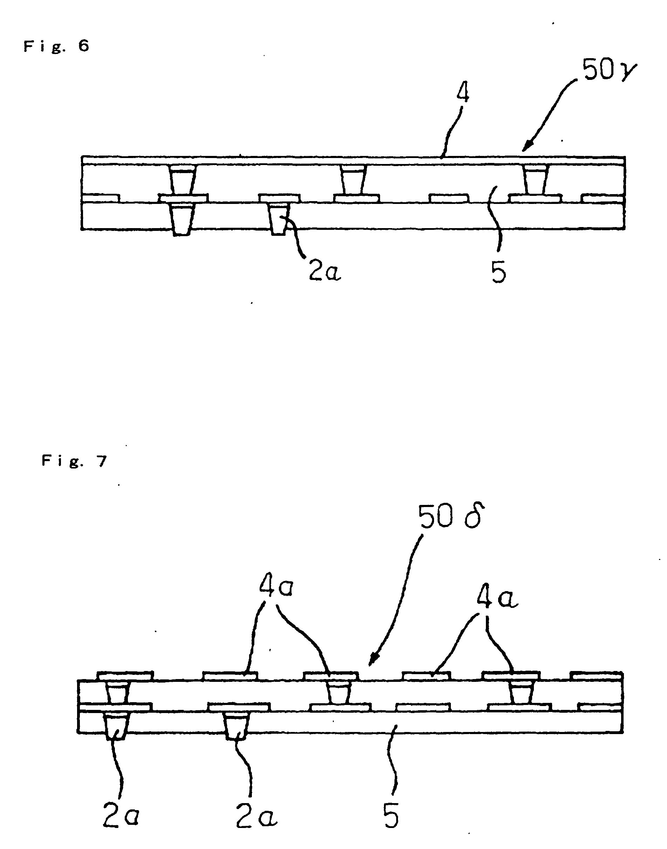

Figs. 4 to 11 are explanatory views of a second embodiment mode of a multi-layer wiring board manufacturing method according to the present invention. According to this embodiment mode, a row material is processed to prepare plural types of basic wiring boards 50 (for example, 50α, 50 β , 50 γ and 50 δ ) composing a multi-layer wiring board, and arbitrary boards are combined from the plural types of basic wiring boards and laminated to produce a multi-layer wiring board 51 (for example, 51a, 51b, 51c or 51d). Figs. 4 to 7 are explanatory views of a basic wiring board manufacturing method or respective basic wiring boards. Figs. 4(A) to 4(D) show a method of manufacturing a first example 50 α of the basic wiring boards in step order. Fig. 5 shows a second example 50 β of the basic wiring boards. Fig. 6 shows a third example 50 γ of the basic wiring boards. Fig. 7 shows a fourth example 50 δ of the basic wiring boards.

First, a method of manufacturing the first example 50 α will be described with reference to Figs. 4(A) to 4(D).

(A) First, as shown in Fig. 4(A), a multi-layer metal plate 1a is prepared. The multi-layer metal plate 1a may be the same as for example the multi-layer metal plate 1a shown in Fig. 1(A). In other words, a laminate obtained by laminating a wiring film forming metal layer 4 made of copper foil having a thickness of for example 18 µm on one main surface of a bump forming metal layer 2 made of copper foil having a thickness of 100 µm through an etching stop layer 3 made of a nickel layer having a thickness of for example 2 µm is prepared.

(B) Next, with respect to the above multi-layer metal plate 1a, the bump forming metal layer 2 and the etching stop layer 3 are patterned by selective etching to form bumps 2a for interconnecting upper and lower wirings. Then, when the selective etching of the bump forming metal layer 2 is completed, etching is conducted for the etching stop layer 3 using as a mask copper that is a material which forms the bump forming metal layer 2 and the wiring film forming metal layer 4.

After that, an insulating film 5 made of for example a resin is bonded onto a forming surface of the above bumps 2a so as to expose only the top portions of the bumps. Then, as shown in Fig. 4(B), a surface of the multi-layer metal plate 1a on the side where the top portions of the bumps 2a protrude is made to face a wiring film forming metal thin plate 6 made of, for example, copper.

(C) Next, as shown in Fig. 4(C), the above wiring film forming metal thin plate 6 is connected with the bumps 2a and laminated on the bump 2a forming surface side.

(D) Next, the wiring film forming metal layer 4 of the above multi-layer metal plate 1a and the above wiring film forming metal thin plate 6 are patterned by selective etching to form wiring films 4a and 6a. Thus, the basic wiring board 50 α is manufactured. The wiring films 4a become upper layer wiring films and the wiring films 6a become lower layer wiring films.

Fig. 5 shows the basic wiring board 50 β . This can be manufactured by selectively etching the wiring film forming metal thin plate 6 to form only the wiring films 6a without selectively etching the wiring film forming metal layer 4, that is, without forming the wiring films 4a of the upper layer in the step of the manufacturing method shown in Fig. 4(D) of Fig. 4.

Fig. 6 shows the basic wiring board 50 γ . The basic wiring board 50 γ can be manufactured by the same steps as the steps shown in Figs. 1(A) to 1(D).

Fig. 7 shows the basic wiring board 50 δ . An insulating film 5 is formed on a bump 2a forming side surface of the basic wiring board 50 γ shown in Fig. 6 so as to expose only the top portions of the bumps 2a from the insulating film 5, and the wiring film forming metal layer 4 is patterned by photo etching to form wiring films 4a. Thus, the basic wiring board 50 δ can be manufactured.

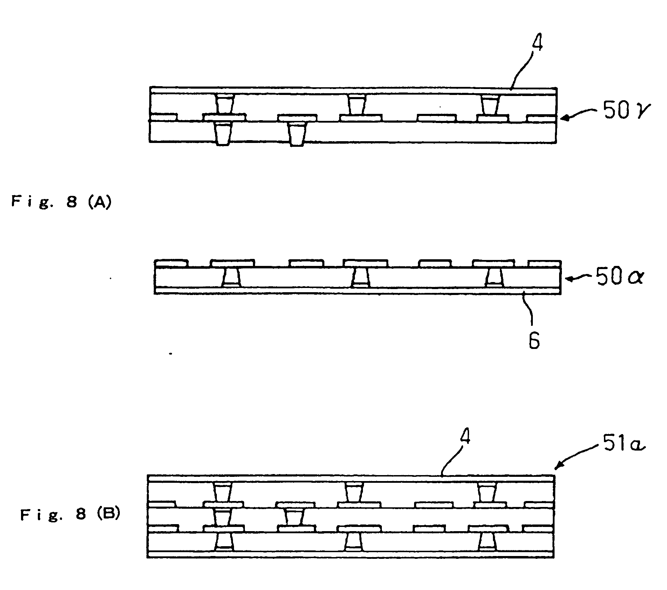

Figs. 8 to 11 are explanatory views of examples 51a to 51d of respective multi-layer wiring boards manufactured by combining the above basic wiring boards 50 α , 50 β , 50 γ and 50 δ and laminating them. Fig. 8(A) shows the basic wiring boards 50 γ and 50 α used for manufacturing the multi-layer wiring board 51a. Fig. 8(B) shows a state in which the basic wiring board 50 γ is laminated on the upper surface of the basic wiring board 50 α. Then, the wiring film forming metal layer 4 being the uppermost layer and the wiring film forming metal thin plate 6 being the lowermost layer in the laminate with the state shown in Fig. 8(B) are patterned by for example photo etching to form wiring films 4a and 6a (not shown). Thus, the multi-layer wiring board 51a with 4 layers is manufactured.

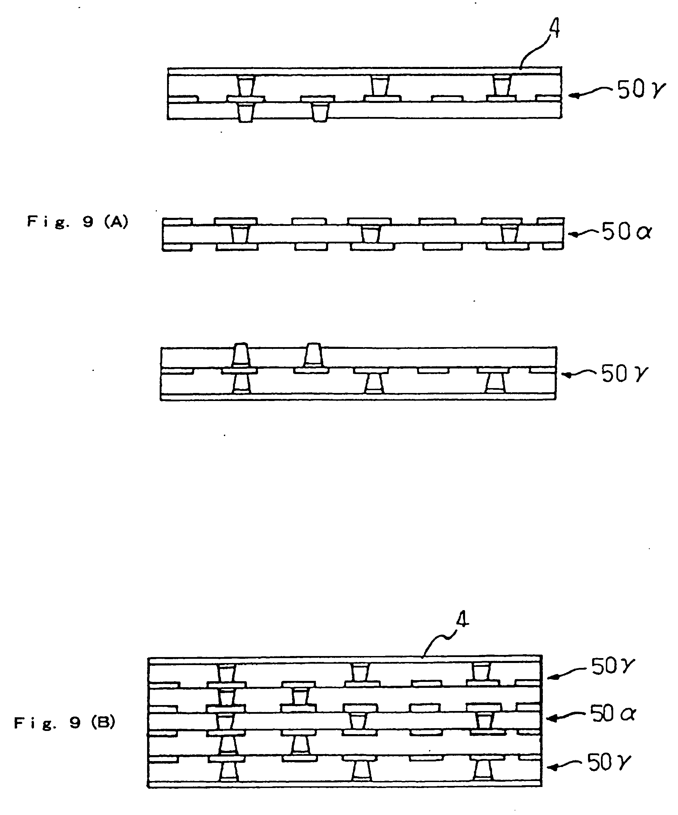

Fig. 9 (A) shows the basic wiring boards 50 γ, 50 α, and 50 γ used for manufacturing the multi-layer wiring board 51b. Fig. 9 (B) shows a state in which the basic wiring boards 50 γ and 50 γ sandwich the basic wiring board 50α and are laminated in a vertical direction such that their respective bump 2a sides face the basic wiring board 50α side. Then, the wiring film forming metal layers 4 and 4 being the uppermost layer and the lowermost layer in the laminate with the state shown in Fig. 9(B) are patterned by for example photo etching to form wiring films 4a and 4a (not shown). Thus, the multi-layer wiring board 51b with 6 layers is manufactured.

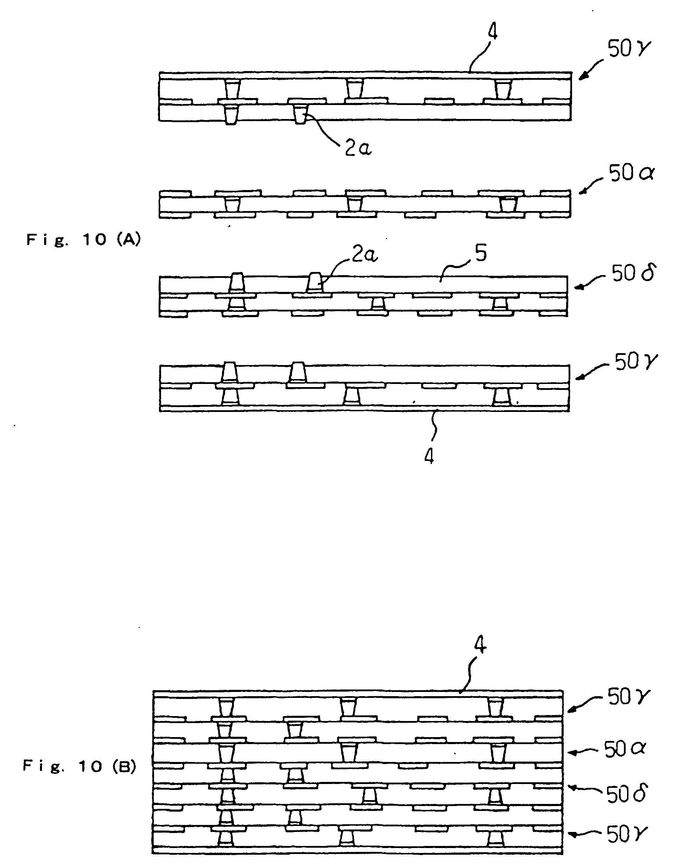

Fig. 10 (A) shows the basic wiring boards 50 γ , 50 α , 50 δ and 50 γ used for manufacturing the multi-layer wiring board 51c (not shown) . Fig. 10 (B) shows a state in which the basic wiring board 50 δ in which a bump 2a side surface is oriented to face upward is laminated on the basic wiring board 50 γ in which a bump 2a side surface is oriented to face upward, the basic wiring board 50 α is laminated on the basic wiring board 50 δ , and the basic wiring board 50 γ in which a bump 2a forming side is oriented to face downward is laminated on the basic wiring board 50 α. Then, the wiring film forming metal layers 4 and 4 as the uppermost layer and the lowermost layer of the laminate in the state shown in Fig. 10(B) are patterned by for example photo etching to form wiring films 4a and 4a (not shown). Thus, the multi-layer wiring board 51c with 8 layers is manufactured.

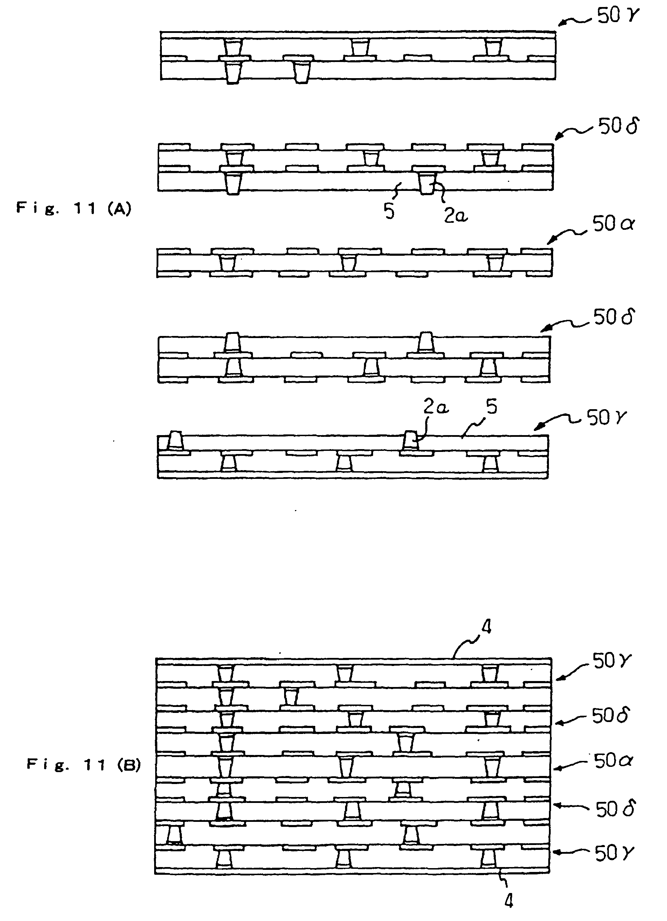

Fig. 11 (A) shows the basic wiring boards 50 γ, 50 α , 50 δ and 50 γ used for manufacturing the multi-layer wiring board 51d. Fig. 11(B) shows a state in which the basic wiring board 50 δ whose bump 2a side surface is oriented to face upward is laminated on the basic wiring board 50 γ whose bump 2a side surface is oriented to face upward, the basic wiring board 50 α is laminated on the basic wiring board 50 δ, the basic wiring board 50 δ whose bump 2a and insulating film 5 forming side is further oriented to face downward is laminated on the basic wiring board 50 α , and further, the basic wiring board 50 γ whose bump 2a and insulating film 5 forming side is oriented to face downward is laminated on the basic wiring board 50 δ . Then, the wiring film forming metal layers 4 and 4 being the uppermost layer and the lowermost layer of the laminate in the state shown in Fig. 11 (B) are patterned by for example photo etching to form wiring films 4a and 4a (not shown). Thus, the multi-layer wiring board 51d with 10 layers is manufactured.

As described above, it is also possible to adopt a mode in which a row material is processed to prepare plural types 50 α, 5 β, 50 γ, and 50 δ of basic wiring boards 50 composing the multi-layer wiring board, and arbitrary boards are combined from the plural types of basic wiring boards and laminated to manufacture the multi-layer wiring boards 51a, 51b, 51c and 51d. Thus, the multi-layer wiring board 51 with the arbitrary number of layers (for example, 4 to 10 layers) can be obtained.

Also in the case of the second embodiment mode of a multi-layer wiring board manufacturing method according to the present invention, substantially the same effect as that obtained by the first embodiment mode can be obtained.

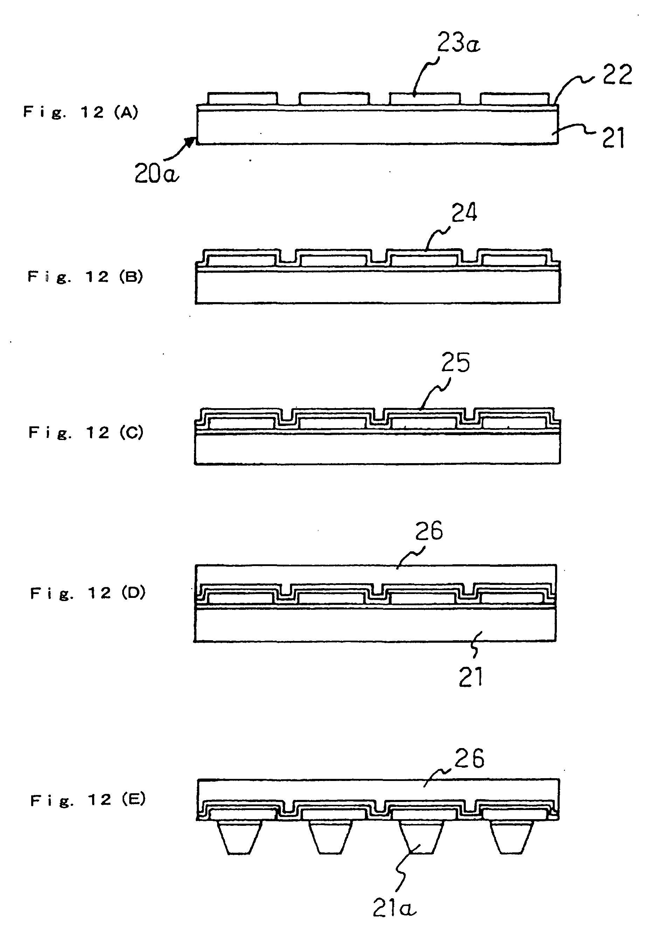

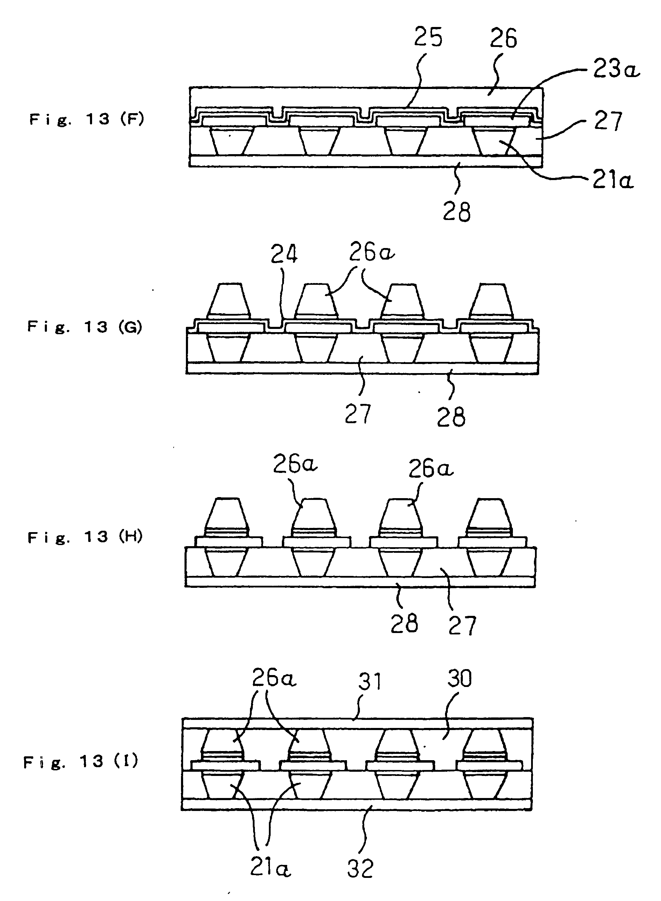

Figs. 12 (A) to 12(E), and Figs. 13(F) to 13(I) are sectional views showing in order steps (A) to (I) in accordance with a third embodiment mode of a multi-layer wiring board manufacturing method of the present invention.

(A) A multi-layer metal plate 20a in which a wiring film forming metal layer 23 (not shown) made of copper foil is laminated on one of surfaces of a bump forming metal layer 21 made of copper foil through an etching stop layer 22 made of nickel is prepared, and the wiring film forming metal layer 23 is patterned by selective etching to form wiring films 23a. At this time, the etching stop layer 22 acts to prevent the bump forming metal layer 21 from being etched. Fig. 12(A) shows a state after the formation of the wiring films 23a.

(B) Next, as shown in Fig. 12(B), a thin copper film 24 is plated on a wiring film 23a forming side surface of the multi-layer metal plate 20a. The copper film 24 acts to prevent etching of an etching stop layer (25), which is made of nickel and is formed on the copper film 24 in the next step, when the above etching stop layer 22 is selectively etched later. Note that, by conducting precise control of etching thickness, it is not impossible to omit the step of forming the copper film 24. Thus, this step is not necessarily essential.

(C) Next, as shown in Fig. 12(C), the etching stop layer 25 made of nickel is formed on a wiring film 23a forming side surface of the above multi-layer metal plate 20a by plating.

(D) Next, as shown in Fig. 12(D), a bump forming metal layer 26 made of copper is formed on the wiring film 23a forming side surface of the multi-layer metal plate 20a by clad lamination or plating.

(E) Next, as shown in Fig. 12(E), the bump forming metal layer 21 and the etching stop layer 22 of the above multi-layer metal plate 20a are patterned by selective etching to form bumps 21a.

(F) Next, an insulating film 27 is bonded to the bumps 21a on a bump 21a forming side surface of the above multi-layer metal plate 20a such that it is broken through by the bumps 21a so as to cause the top portions thereof to protrude. After that, a wiring film forming metal thin plate 28 is connected with the bumps 21a and laminated on the insulating film 27. Fig. 13(F) shows a state after bonding of the wiring film forming metal thin plate 28.

(G) Next, as shown in Fig. 13(G), the above bump forming metal layer 26 and the etching stop layer 25 are patterned by selective etching to form bumps 26a.

(H) Next, as shown in Fig. 13(H), the above copper film 24 is etched to electrically insulate between the respective wiring films 23a.

(I) Next, an insulating film 30 is bonded to a bump 26a forming side surface of the multi-layer metal plate 20a such that it is broken through by the bumps 21a to protrude the top portions thereof. After that, a wiring film forming metal thin plate 31 is connected with the bumps 26a and laminated on the insulating film 30. Fig. 13(I) shows a state after bonding of the wiring film forming metal thin plate 31.

After that, although not shown, the above wiring film forming metal thin plate 28 and 31 are patterned by selective etching to form wiring films. Thus, a wiring board with 3 layers in which interlayer connections are provided through the bumps 21a and 26a can be obtained.

Here, the example of the wiring plate with 3 layers is described. However, it can be also applied to a multi-layer wiring plate with more layers. In other words, by combining the metal thin plate 28 shown in Fig. 13(F) (not shown) which has been patterned and another metal thin film bonded to the bumps 26a shown in Fig. 13(H) such that it breaks through an insulating layer (not shown) so as to cause the top portions thereof to protrude (not shown), a multi-layer plate with 3 or more layers can be also obtained.

Also in this multi-layer wiring board manufacturing method, as compared with a conventional case, a region of a portion required for interconnecting upper and lower wirings can be extremely narrowed by making a diameter thereof for example 0.1 mm or less. Thus, not only a direct effect is obtained with respect to improvement of integration due to the narrowing of an necessary area therefor but also an indirect effect can be obtained in that adverse influence on other wiring films such that they have to be forced to make a detour is reduced. In other words, due to the indirect effect that adverse influence on other wiring films is reduced, an effect is produced in that the number of wiring films that are forced to make a detour can be reduced and the detour length of the wiring film which is forced to make a detour can be also shortened.

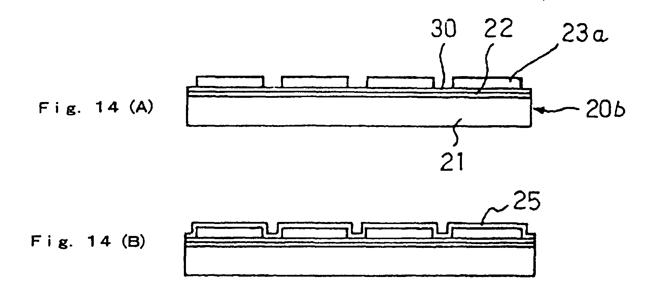

Figs. 14(A) and 14(B) are sectional views showing steps (A) and (B) being a part of a modified example obtained by modifying the third embodiment mode of a multi-layer wiring board manufacturing method according to the present invention as shown in Figs. 12 and 13. In this modified example, a multi-layer metal board 20b in which an etching stop layer 22 made of nickel is formed on a bump forming metal layer 21 made of copper, a plating base layer 30 made of copper is formed on the etching stop layer 22, and wiring films 23a having a predetermined pattern are formed on the plating base layer 30 by plating copper using a selectively formed resist film as a mask is used. Fig. 14(A) shows the multi-layer metal board 20b and Fig. 14(B) shows a state after an etching stop layer 25 made of nickel is formed on the multi-layer metal board 20b. These correspond to the step shown in Fig. 12(C). After that, processing performed subsequent to the step shown in Fig. 12(D) in the third embodiment mode shown in Figs. 12 and 13 is conducted.

Also in this example, the same effect as in the third embodiment mode shown in Figs. 12 and 13 can be obtained and a pattern having higher precision than a pattern by etching can be formed.

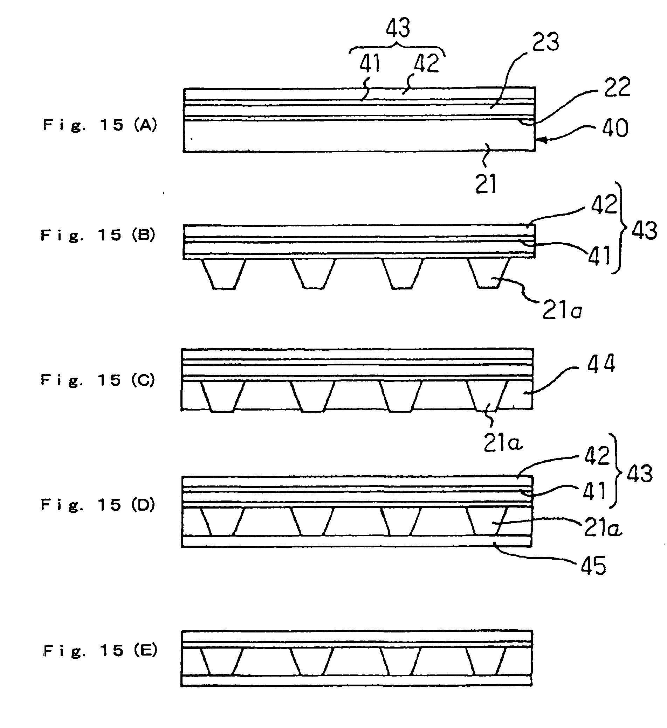

Figs. 15(A) to 15(E) are sectional views showing in order of steps of a fourth embodiment mode of a multi-layer wiring board manufacturing method according to the present invention.

(A) As shown in Fig. 15(A), a multi-layer metal plate 40 with 5 layers in which an etching stop layer 22 made of nickel is laminated on a bump forming metal layer 21 made of copper, a wiring film forming metal layer 23 made of copper is laminated on the etching stop layer 22, a layer 41 made of nickel is laminated on the wiring film forming metal layer 23, and a copper layer 42 is formed on the layer 41 is prepared as a multi-layer metal plate. The nickel layer 41 and the copper layer 42 of the multi-layer metal plate 40 compose a reinforcing layer 43 which is peeled off later and act to prevent the multi-layer metal plate 40 from becoming liable to cause a defect such as warping and bending due to insufficient mechanical strength. In addition, by continuously protecting the surface of the wiring film forming metal layer during a period of from the first step to the wiring film patterning step, they act to prevent the damage or the like to the surface during for example a press step and therefore to prevent a defect from being caused in formed wiring films. Further, they also act to protect the surface of the wiring film forming metal layer from a chemical solution and to prevent deposition of contaminants on the surface.

Note that the multi-layer metal plate 40 may be formed as follows. The nickel layer 41 is formed by plating on the surface of the wiring film forming metal layer 23 of the multi-layer metal plate with 3 layers which is composed of the bump forming metal layer 21, the etching stop layer 22, and the wiring film forming metal layer 23, and the copper layer 42 is formed by plating on the surface of the nickel layer 41. Alternatively, it may be formed by laminating 5 clad layers composed of the bump forming metal layer 21, the etching stop layer 22, the wiring film forming metal layer 23, the nickel layer 41, and the copper layer 42.

(B) Next, as shown in Fig. 15(B), the bump forming metal layer 21 is patterned by selective etching to form bumps 21a.

(C) Next, as shown in Fig. 15(C), an insulating film 44 is bonded to a bump 21a forming side surface of the multi-layer metal plate 40 such that it is broken through by the bumps 21a to cause the top portions thereof to protrude.

(D) After that, a wiring film forming metal thin plate 45 is connected with the bumps 21a and laminated on the insulating film 44. Fig. 15(D) shows a state after bonding of the wiring film forming metal thin plate 45. In this state, the mechanical strength of the multi-layer metal plate 40 is greater than that in the state shown in Fig. 15(B). Thus, there is almost no possibility that it is warped and bent to cause a defect.

(E) After that, the reinforcing layer 43 is peeled off as shown in Fig. 15(E) so that the insulating film can be formed by patterning the wiring film forming metal layer 23 and the wiring film forming metal thin plate 45 by selective etching.

According to such a fourth embodiment mode, the multi-layer metal plate in a state in which it is thin and its mechanical strength is low is reinforced with the reinforcing layer 43. Thus, workability is improved and a fraction defective can be reduced. In addition, the surface of the wiring film forming metal layer is continuously protected during a period of from the first step to the wiring film patterning step. Thus, damage or the like to the surface during for example a pressing step can be prevented and it can be prevented that a defect is caused in formed wiring films. Further, the surface of the wiring film forming metal layer can be protected from a chemical solution and deposition of contaminants on the surface can be prevented.

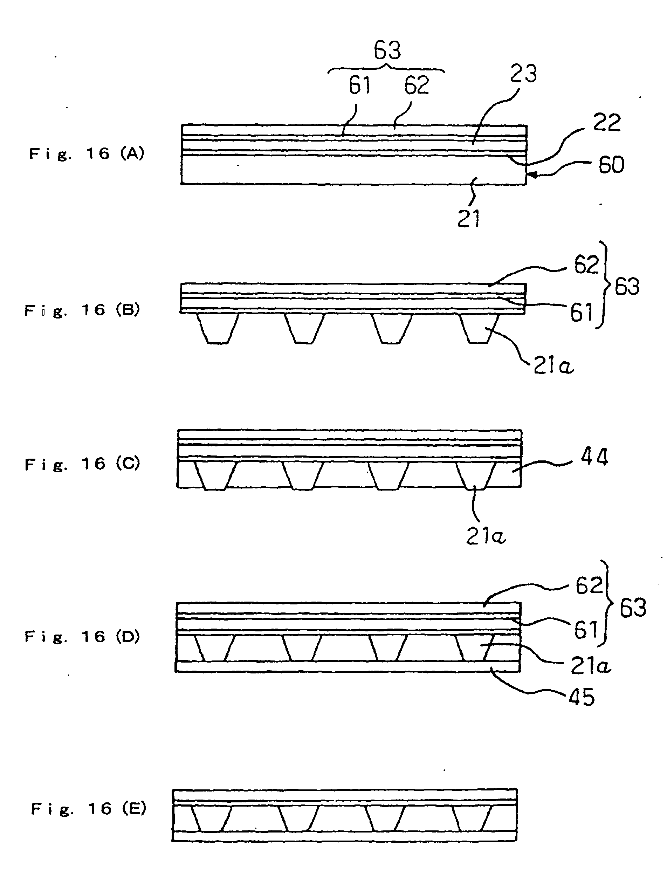

Figs. 16(A) to 16(E) are sectional views showing in order of steps a fifth embodiment mode of a multi-layer wiring board manufacturing method according to the present invention.

(A) As shown in Fig. 16(A), a multi-layer metal plate 60 in which an etching stop layer 22 made of nickel is laminated on a bump forming metal layer 21 made of copper and a wiring film forming metal layer 23 made of copper is laminated on the etching stop layer 22 is prepared as a multi-layer metal plate. A heat resistant film 62 having a peeling layer 61 is laminated on the wiring film forming metal layer 23 of the multi-layer metal plate 60.

The peeling layer 61 and the heat resistant film 62 compose a reinforcing layer 63 which is peeled off later and act to prevent the multi-layer metal plate 60 from becoming liable to cause a defect such as warping and bending due to insufficient mechanical strength. In addition, the surface of the wiring film forming metal layer is continuously protected during a period of from the first step to the wiring film patterning step so that they act to prevent damage or the like to the surface during for example a pressing step and to prevent a defect from being caused in formed wiring films. Further, they also act to protect the surface of the wiring film forming metal layer from a chemical solution and to prevent deposition of contaminants on the surface.

Note that the peeling layer 61 is formed at a thickness of for example 1 to 3 µm using an organic system agent. The organic system agent is made of a kind or plural kinds of materials selected from the group consisting of an organic compound containing nitrogen, an organic compound containing sulfur and a carboxylic acid.

Of those, the nitrogen-containing organic compound includes a nitrogen-containing organic compound having a substituent. As the nitrogen-containing organic compound, specifically, it is preferred that 1,2,3-benzotriazole, carboxybenzotriazole, etc. which are a triazole compound having a substituent are used. As the sulfur-containing organic compound, it is preferred that mercaptobenzothiazole, thiocyanuric acid, etc. are used. Moreover, as the carboxylic acid, it is preferred that particularly a monocarboxylic acid is used and that among these, oleic acid, linoleic acid, linolenic acid, etc. are used.

Furthermore, the heat resistant film 62 is formed to have a thickness of, for example, 10 to 100 µm by using a polymer. As the polymer, it is preferred that a polyphenylene sulfide resin, a polyetherimide resin, a liquid crystal polymer film or polyetheretherketone resin, etc. is used.

(B) Next, as shown in Fig. 16(B), the bump forming metal layer 21 is patterned by selective etching to form bumps 21a.

(C) Next, as shown in Fig. 16(C), an insulating film 44 is bonded to a bump 21a forming side surface of the multi-layer metal plate 40 such that it is broken through by the bumps 21a so as to cause the top portions thereof to protrude.

(D) After that, a wiring film forming metal thin plate 45 is connected with the bumps 21a and laminated on the insulating film 44. Fig. 16(D) shows a state after bonding of the wiring film forming metal thin plate 45. In this state, the mechanical strength of the multi-layer metal plate 40 is greater than that in the state shown in Fig. 16(B). Thus, there is almost no possibility that it is warped and bent to cause a defect.

(E) After that, the reinforcing layer 63 is peeled off as shown in Fig. 16(E) such that the wiring film can be formed by patterning the wiring film forming metal layer 23 and the wiring film forming metal thin plate 45 by selective etching.

According to such a fifth embodiment mode, the same effect as in the fourth embodiment mode can be obtained. In addition to this, an effect can be obtained particularly in that simplified process is realized. In other words, when the reinforcing layer 43 is made of metal such as nickel or copper as in the fourth embodiment mode, the number of steps is increased because etching is required for peeling the layer. On the other hand, in the case where the reinforcing layer 63 is composed of the peeling layer 61 and the heat resistant film 62 as in the fifth embodiment mode, when the process is about to be transferred to the wiring film patterning step (when it is transferred from Fig. 16 (D) to 16(E)), it is sufficient to merely peel the heat resistant film and thus simplified process can be realized as a result.

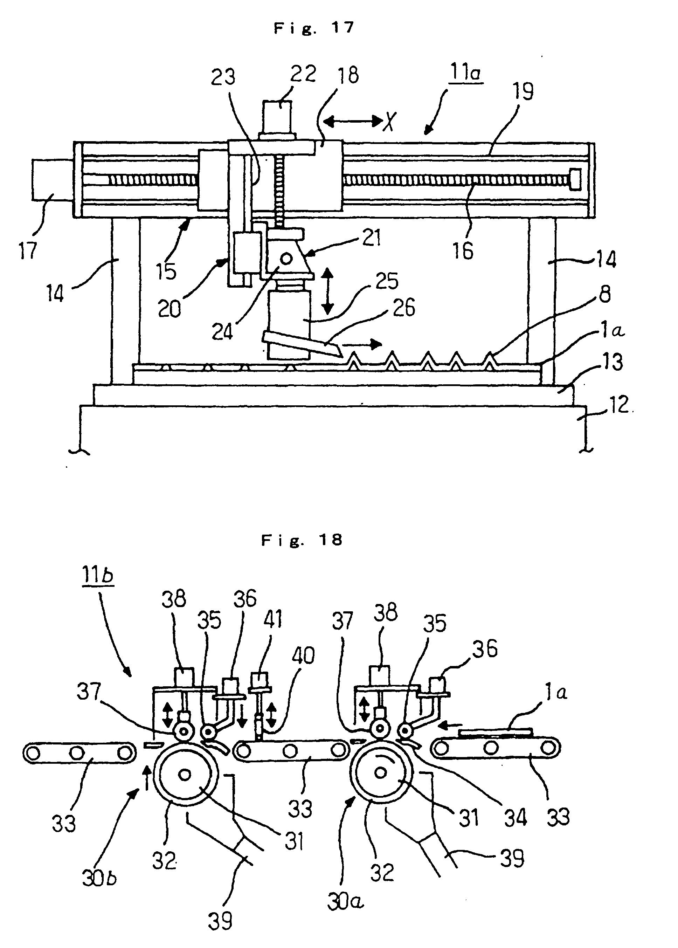

Fig. 17 is a side view showing a polishing machine 11a of using for use of a sixth embodiment mode of a multi-layer wiring board manufacturing method according to the present invention. In the drawing, 12 denotes a base (base member) of the polishing machine 11a for wiring board and 13 denotes a suction table provided on the base 12. When the multi-layer metal plate 1a is located on the upper surface of the table, the table strongly sucks the plate by vacuum suction and holds it. 14, 14, ... denote column supports. An X-directional moving mechanism 15 which moves in an X-direction (horizontal direction in the drawing) is supported by the column supports 14, 14, ...

The above X-directional moving mechanism 15 causes an X-directional moving drive motor 17 to rotate a spindle 16 extended in the X-direction so that an X-directional moving body 18 is moved in the X-direction while it is guided by an X-directional guide body 19 in parallel to the metal plate 1a. This corresponds to the cutter moving in parallel to the metal plate 1a of Claim 16.

The X-directional moving mechanism 15 will be specifically described. A male screw is formed on an outer circumferential surface of the above spindle 16. In addition, the X-directional moving body 18 has a female screw portion which is not shown. The above spindle 16 is screwed into the female screw portion. Thus, when the spindle 16 is rotated by the motor 17, the X-directional moving body 18 can be moved in the X-direction in parallel to the metal plate 1a.

20 denotes a Y-directional moving mechanism attached perpendicular to the above X-directional moving body 18, which moves a Y-directional moving mechanism 21 in a Y-direction (vertical direction to the metal plate 1a in Fig. 17). In other words, when a Y-directional moving drive motor 22 is rotated, the Y-directional moving mechanism 20 moves the Y-directional moving mechanism 21 while guiding it in the Y-direction by a Y-directional guide body 23 set vertical to the

metal plate 1a. The Y-directional moving mechanism 20 corresponds to a height adjusting mechanism in claim 17.

When a Z-directional moving drive motor which is not shown is rotated, the above Z-directional moving mechanism 21 can move a Z-directional moving body 24 in a Z direction (direction from a paper rear side to a paper front side or reversely in parallel to the metal plate 1a in Fig. 17). A cutter holding means 25 for holding a cutter 26 having a large width is fixed to the Y-directional moving body 24.

Polishing by the polishing machine 11a for wiring circuit members as shown in Fig. 17 is conducted as follows.

First, the multi-layer metal plate 1a is set on the suction table 13, strongly sucked by vacuum suction, and held. Note that the metal plate 1a is polished by the polishing machine 11a for wiring board.

Then, the cutter holding means 25 is moved to the left side such that the cutter 26 is located in the left side of the left end of the metal plate 1a. In addition, a Y-directional positioning is conducted according to the rotation of a Y-directional moving drive motor which is not shown and further, the height of the cutter 26 is adjusted according to the rotation of the Y-directional moving drive motor 22. When the adjustment is completed, the cutter holding means 25 is moved to the right side by the X-directional moving drive motor 17 to conduct polishing. Fig. 17 shows a state during the polishing.

When moving to the right side is completed, the cutter holding means 25 is returned to the initial left side end in the X-direction. Next, the cutter holding means 25 is moved in the Z-direction by the width of the cutter 26. In addition, the cutter holding means 25 is further moved to the right side to conduct polishing.

When such polishing is repeated and polishing over the entire region of the metal plate 1a completed, the metal plate 1a is removed, a next metal plate 1a is set, and polishing to this is similarly repeated.

According to such polishing using the polishing machine 11a for wiring board, when the cutter 26 is moved by only 1 stroke, polishing can be conducted on an area corresponding to the product of a length of 1 stroke and the width of the cutter 26. Thus, polishing efficiency can be improved. Accordingly, a large number of metal plates 1a can be polished in an extremely short time and in a manner of mass production.

Therefore, manufacturing costs and manufacturing prices for a wiring board composed of the metal plate 1a and an electronic member using the wiring board, and further an electronic device using the electronic member can be reduced.

Note that a vibration means for applying low frequency vibration or ultrasonic vibration for the cutter 26 is provided to the above cutter holding means 25, and it can be moved parallel to the surface of the metal plate 1a to conduct polishing while the low frequency vibration or the ultrasonic vibration for the cutter 26 is conducted by the cutter holding means 25. Thus, the surface can be smoothly and preferably finished.

Fig. 18 is a side view showing a polishing machine for use of a seventh embodiment mode of a multi-layer wiring board manufacturing method of the present invention. In the drawing, 30a denotes a rough polishing portion and 30b denotes a finish polishing portion. Both are located such that finish polishing is conducted by the finish polishing portion 30b immediately after the metal plate 1a for which rough polishing is completed by the rough polishing portion 30a is aligned. With respect to the rough polishing portion 30a and the finish polishing portion 30b, roughnesses of whetstones 32 around whetstone rollers 31 rotated by motors which are not shown are different. The whetstone roller 31 of the rough polishing portion 30a is rough and the whetstone roller 31 of the finish polishing portion 30b is fine. Except for this point, the configuration is substantially the same. Thus, only one 30a will be described in detail and the description of different point with respect to the other 30b will be omitted.

33 denotes a carrying belt for carrying the metal plate 1a. 34 denotes a cover which is provided to prevent the metal plate 1a from deviating downward. 35 denotes a carrying roll which is vertically shifted by an air cylinder 36 and acts to carry the metal plate 1a between the whetstone roller 31 and a backup roller 37.

The above backup roller 37 presses the metal plate 1a to the whetstone roller 31 by the air cylinder 36.

39 denotes a dust collecting cover for collecting dust produced by polishing. 40 denotes an alignment stopper located over the carrying belt 33 for carrying from the rough polishing portion 30a to the finish polishing portion 30b, which is driven by an air cylinder 41 and adjusts the direction of the metal plate 1a for which finish polishing is to be conducted after the rough polishing.

Polishing by a polishing machine 11b for wiring board as shown in Fig. 18 is conducted as follows.

When the metal plate 1a is put on the carrying belt 33 in the front side (right side in Fig. 18) of the rough polishing portion 30a, the metal plate 1a is carried by the carrying belt 33 and guided by the carrying roller 35 between the whetstone roller 31 and the backup roller 37 which rotate. Then, it is entered with pressing between the whetstone roller 31 and the backup roller 37 which rotate, and during passing therebetween, the metal plate 1a is roughly polished by the whetstone roller 31 and discharged. Note that the metal plate 1a is set such that the surface to be polished is in contact with the whetstone roller 31.

Then, it is carried to the finish polishing portion 30b side by the carrying belt 33 and aligned by an alignment stopper 40. When the alignment is completed, the alignment stopper 40 is lifted, the metal plate 1a is carried to the finish polishing portion 30b side by the carrying belt 33, guided between the whetstone roller 31 and the backup roller 37, and polished for finish. Then, it is discharged from a space between the whetstone roller 31 and the backup roller 37 and carried by the carrying belt 33 to complete polishing.

According to such a polishing machine 11b for wiring board, when the metal plate 1a is set on the carrying belt 33 in the front side of the rough polishing portion 30a, the rough polishing and the finish polishing are automatically conducted in succession. Thus, polishing with high efficiency can be made to proceed in a manner of mass production.

Note that, instead of the polishing rollers, buff rollers may be used as the rollers 31 and 31 of the rough polishing portion 30a and the finish polishing portion 30b. In this case, it is needless to say that a roller which is rough with respect to surface roughness is used as the buff roller 31 of the rough polishing portion 30a and a roller which is fine with respect to surface roughness is used as the buff roller of the finish polishing portion 30b.

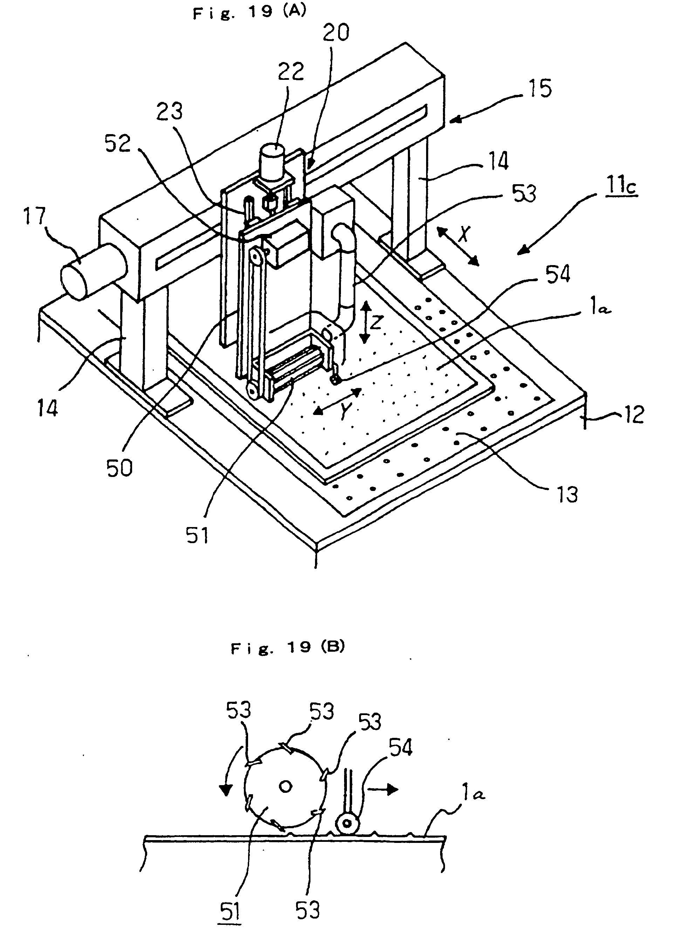

Figs. 19(A) and 19(B) show a polishing machine 11c of an eighth embodiment mode of a multi-layer wiring board manufacturing method according to the present invention. Fig. 19(A) is a perspective view of the polishing machine 11c for wiring board and Fig. 19 (B) is a side view showing a state of polishing by a cutting roller.

12 denotes a base (base member) which has in its inner portion an X-directional carrying mechanism for carrying a pair of column supports 14 and 14 in an X-direction through both side portions, which is not shown. The X-directional carrying mechanism corresponds to a cutting roller parallel moving mechanism of claim 22. 13 denotes a suction table provided on the base 12 within moving regions of the both side portions in which the column supports 14 and 14 move, which strongly sucks the metal plate 1a by vacuum suction and holds to support it.

15 denotes an Y-directional moving mechanism, which moves a Y-directional moving body (not shown) by a Y-directional moving motor 17. 20 denotes a Z-directional moving mechanism attached to the Y-directional moving body (not shown), which guides a Z-directional moving plate 50 in a Z-direction by a Z-directional guide body 23 and moves it by a Z-directional moving drive motor 22. The Z-directional moving mechanism 20 corresponds to a height adjusting mechanism of claim 22.

A cutting roller 51 is provided to be rotatable in the lower portion of the above Z-directional moving plate 50 and a motor 52 for rotating it is provided in the upper portion. In the cutting roller 51, a plurality of cutters 53, 53, (Fig. 19(B))... each having a large width are formed on its peripheral surface in parallel to the rotational axis of the cutting roller 51 and cutting edges are protruded in a direction close to the tangential direction. The cutting roller 51 is attached to the Z-directional moving body 50 in a direction in which the rotational axis becomes parallel to the surface of the suction table 13. In addition, a reference guide roller 54 which acts as a pilot is attached to the Z-directional moving plate 50 slightly before the cutting roller 51. The reference guide roller 54 is controlled such that it is passed through a portion in which bumps are not present and acts as a pilot in Y-directional position control.

The cutting roller 51 in the lower portion of the Z-directional moving plate 50 is rotated by the above motor 52 in the upper portion. Specifically, a belt is put between a pulley fixed to the rotational shaft of the motor 52 and a pulley fixed to the rotational shaft of the cutting roller 51. The rotation of the motor 52 is transmitted to the cutting roller 51 through the belt so that the cutting roller 51 is rotated as shown in Fig. 19(B).

Note that 55 denotes a dust collecting unit for collecting dust produced by polishing.

Polishing by the polishing machine 11c for wiring board as shown in Fig. 19 is conducted as follows.

The metal plate 1a is set on the suction table 13. The metal plate 1a is then strongly held by vacuum suction. A height of the cutting roller 51 is adjusted by driving the Z-directional moving drive motor 22. While the X-directional moving mechanism which is provided in the base 12 and not shown is moved in the X-direction, the surface portion of the metal plate 1a on the suction table 13a is polished by cutting roller 51 rotated by the motor 52. Then, when polishing by movement corresponding to 1 stroke in the X-direction is completed, it is returned to the X-direction. Next, the cutting roller 51 is shifted by about its width by the Y-directional moving mechanism 15 and next polishing corresponding to 1 stroke in the X-direction is conducted. Hereafter, polishing is continued until polishing over the entire region of the metal plate 1a completed.

According to such polishing using the polishing machine 11c for wiring board as shown in Fig. 19, when it is moved by only 1 stroke while the cutting roller 51 is rotated, polishing can be conducted by an area corresponding to the product of a length of 1 stroke and the width of the cutter 53 of the cutting roller 51. Thus, polishing efficiency can be improved. Accordingly, a large number of metal plates 1a are polished in an extremely short time and in a manner of mass production.

Therefore, manufacturing costs and the price of a manufactured wiring board composed of the metal plate 1a and an electronic member using the wiring board, and an electronic device using the electronic member can be reduced.

Figs. 20(A) to 20(D) are explanatory views of a ninth embodiment mode of a multi-layer wiring board according to the present invention. Fig. 20(A) is a sectional view of a metal (copper) plate 1a containing mainly copper, Fig. 20(B) is a sectional view of a processed metal plate 1a and a copper plate (layer) 202 bonded thereto, Fig. 20(C) shows a section of the copper plate 202 welded with pressure to bumps, and Fig. 20(D) is a table indicating a reason why Vickers hardness of the metal plate 1a is set to 80 to 150 Hv.

The above metal plate 1a shown in Fig. 20(A) is formed by plating a nickel layer 402 (for example 1µm in thickness) on the surface of a substantially pure copper layer 302 which has a thickness of for example about 100µm and is made of tough pitch copper, alloy copper, and electrolytic copper foil. Further, it may be obtained by forming a copper layer (for example 18 µm in thickness) 505 on the surface of the nickel layer 402 by plating or a clad method.

In the metal plate 1a, the copper layer 302 is made of substantially pure copper and its hardness is adjusted (adjusted by the degree of rolling, annealing, composition of plating, or the like) such that Vickers hardness becomes 80 to 150 Hv. This is a characteristic of the metal plate 1a in this embodiment mode.

In the metal plate 1a, the copper layer 302 is selectively etched to form bumps 2a. After a resist used as a mask film at this etching is removed, an insulating sheet is laminated, an insulating layer 7 for interlayer insulation is formed by pressure application, and the copper layer (copper foil) 202 is laminated thereon. Fig. 20(B) shows the metal plate 1a and the copper layer 202 before this lamination and Fig. 20(C) shows the metal plate 1a and the copper layer 202 after the lamination. As in the case of the copper layer 302 of the metal plate 1a, the hardness of the copper layer 202 is also adjusted (adjusted by mixing of an impurity, an annealing manner, or the like) such that Vickers hardness becomes 80 to 150 Hv. This is a characteristic of the copper layer 202 in this embodiment mode.

Fig. 20(D) shows using a table a reason why Vickers hardness is set to 80 to 150 Hv with respect to hardnesses of the copper layer 302 of the metal plate 1a and the copper layer 202 laminated thereon as described above.

Fig. 20(D) specifically shows whether or not respective wiring circuit forming boards manufactured by changing the hardnesses of the copper layer 302 and the copper layer 202 of the metal plate 1a to 62 Hv, 81 Hv, 103 Hv, 135 Hv, and 155 Hv are accepted according to an HO (hot oil) test, a solder heat resistance test, a PCT (pressure cooker test), and a migration test. "o" indicates acceptance and "×" indicates rejection. In Fig. 20(D), the hardness indicates Vickers hardness [Hv] as a matter of course.

Also, the HO test is the following test. A completed copper member (hereinafter referred to as a "work") is immersed for a predetermined time (10 seconds in this example) in silicon oil heated at a predetermined high temperature (260°C in this example). Immediately after that, it is immersed for a predetermined time (20 seconds in this example) in silicon oil kept at a predetermined low temperature (20°C in this example). These operations are repeated predetermined times (for example 50 times). A test piece including a daisy pattern in which copper patterns repeated in a vertical direction through a connection portion are connected in series is used and it is determined whether or not coefficient of variation in a resistance value of a series resistance is 10% or less as compared with an initial value.

The solder heat resistance test is the following test. The work is immersed for a predetermined time in a solder tank which is heated at a predetermined temperature (260°C in this example) and becomes a melting state, and it is examined whether or not failure (peeling of the copper layer 302 or the like) is caused. In addition, it is determined whether or not failure is caused based on whether or not a change in a resistance value of the daisy pattern before and after the above processing is 10% or less.

The PCT is the following test. Water is entered into a pressure vessel. A test piece is put on a cage or the like in the pressure vessel and kept in a position higher than a liquid level of the water. The water is heated at a predetermined temperature (121°C in this example) to keep the inner portion of the pressure vessel at a predetermined vapor pressure (2 atmospheric pressures in this example) for a predetermined time (24 hours in this example). It is examined whether or not a variation in resistance value is within 10% and whether or not failure (peeling of the copper layer 302 or the like) such as blistering or peeling is caused.

The migration test is the following test. A wiring film which is made from a copper layer and in which a comb tooth shaped positive electrode and a comb tooth shaped negative electrode are opposite to each other at a predetermined interval is formed on a wiring circuit forming board. A predetermined voltage (for example DC 50 V) is applied between the electrodes of the wiring film. Thus, it is detected from a migration phenomenon of pattern metal whether or not a short circuit phenomenon between a plus pole and a minus pole is caused in a predetermined time (for example 1000 hours) or whether or not a current leakage which is supposedly caused when an insulating resistance becomes 10⁸ Ω or less by the reduction thereof is caused.

As is apparent from Fig. 20(D), in the case where Vickers hardness is 62 Hv, when a test piece in which electrical connection is provided is tested, it is accepted in accordance with the migration test. However, it is rejected in accordance with the HO test, the solder heat resistance test, and the PCT. Thus, when Vickers hardness is a low value such as 62 Hv, interface peeling is caused between the upper surface of the bump 2a and the copper layer 202, a pressure welding portion contact area therebetween is narrowed, a resistance is increased, and a pressure welding portion between the copper bump and the copper layer is reduced. In addition, because the pressure welding state is unstable, connectivity is deteriorated and long-term reliability is reduced.

Conversely, when Vickers hardness is increased to be larger than 120 Hv, for example, when it is increased to about 155 Hv, there is no problem with respect to the HO test, the solder heat resistance test, the PCT, and the migration test. However, the bump is hard to deform at pressing and the copper layer as shown in Fig. 20(D) is bulged. Thus, when the following patterning is conducted, a photosensitive resist cannot be preferably coated and it cannot be made in contact with a mask in exposure. Accordingly, a problem such as frequent occurrence of defective pattern formation is caused.

In contrast to this, when Vickers hardness is 80 to 150 Hv, satisfied test results are obtained with respect to the HO test, the solder heat resistance test, the PCT, and the migration test. In addition, there is no defective patterning during the process and it is accepted.

Therefore, in this embodiment mode, as described above, the copper layer 302 having Vickers hardness of 80 to 150 Hv is used as a metal plate 1a and a layer having Vickers hardness of 80 to 150 Hv is used as the copper layer 202 to be laminated.

A technique according to this embodiment mode can all be applied to manufacturing of a wiring circuit forming board of a type in which a bump is used as upper and lower wirings interconnecting means using a copper material and wirings formed by copper patterning are electrically connected with each other through the bump.

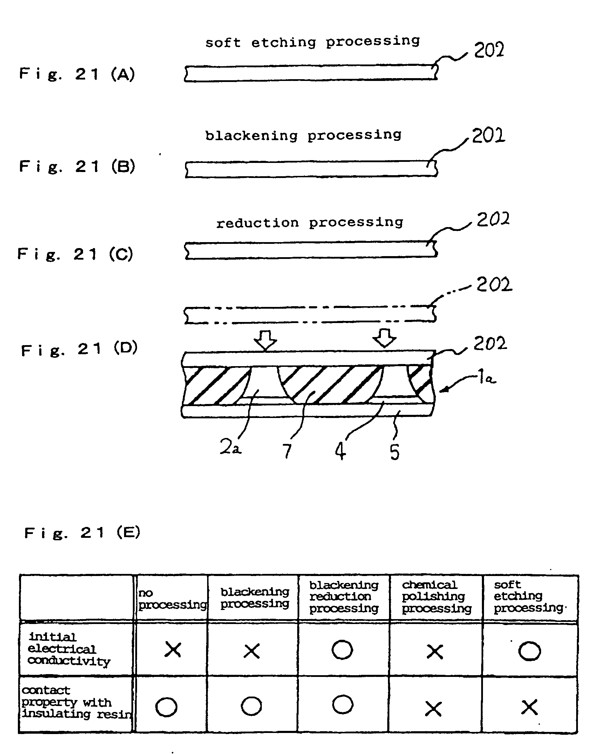

Figs. 21(A) to 21(E) show a tenth embodiment mode of a multi-layer wiring board manufacturing method according to the present invention. Figs. 21(A) to 21(D) are sectional views showing the manufacturing method in step order. Fig. 21(E) shows by way of a table good/poor states of a bump forming member side and copper foil (copper layer) laminated thereon with respect to various processing contents.

(A) Copper foil 202 (corresponding to the copper foil (copper layer) 202 shown in Fig. 20(B)) is prepared and soft etching processing using an ammonium persulfate solution or the like is performed therefor as shown in Fig. 21(A). The prepared copper foil 202 falls under the category of electrolytic copper foil. However, the surface of commercially available foil is firstly processed by zinc plating, processed using chromate, and processed by silane coupling. When this is used without being processed, a hard oxide film and an insulating layer of an organic matter are formed on copper between the upper surface of a copper bump and the surface of a copper wiring film. Accordingly, an electrical connection property after lamination is insufficient.

Thus, as shown in Fig. 21(A), soft etching processing is performed. According to this processing, in order to remove an oxide and an organic matter on the surface of copper to expose a pure copper layer, soft etching bath using an aqueous solution containing mainly ammonium persulfate is used to obtain a pure copper surface.

Therefore, the copper foil 202 may be immediately laminated on the metal plate 1a (see Fig. 20(B)). Note that, in order to improve contact between the copper foil 202 and bumps 2a, it is preferable that the following blackening processing is performed and reduction processing is further performed for the following reason. When the soft etching processing as shown in Fig. 21(A) is performed, the surface becomes a smooth surface so that the contact between the bumps 2a and the copper foil 202 becomes insufficient. Thus, contact between an insulating resin and the copper layer cannot be ensured unless somewhat uneven surface is formed.

(B) Next, as shown in Fig. 21(B), blackening processing is performed. Specifically, oxidation is conducted using for example a hydrogen peroxide solution as a processing solution. Then, needle shaped crystalline matter made of copper oxide and copper is formed on the surface of the copper foil 202. The needle shaped crystalline matter forms unevenness on the surface of the copper foil 202.

(C) Next, as shown in Fig. 21(C), reduction processing is performed. A solution containing mainly for example dimethylaminoborane or caustic soda is used as a reduction solution. Then, of the needle shaped crystalline matter containing mainly the copper oxide which is produced on the surface of the copper foil 202 by the blackening processing shown in Fig. 21(B), the copper oxide is reduced. Thus, a state in which only the copper of the needle shaped crystalline matter is formed on the surface of the copper foil is obtained and the surface of the copper foil 202 becomes a state in which unevenness is produced.

(D) Immediately after that or while storing the foil so as not to oxidize the surface of copper, the copper foil 202 is laminated on the metal plate 1a (which is the same as the metal plate 1a shown in Fig. 20(A)) as shown in Fig. 21(D).

Fig. 21(E) shows the kinds of processings performed for the copper foil 202 and judgement of good/poor with respect to initial electrical conductivity of the copper foil and contact property thereof to the insulating resin in correspondence with the above processings, in which "o" indicates good and "×" indicates poor.

In Fig. 21(E), "no processing" as a kind of processings indicates the case where commercially available electrolytic copper foil for which zinc plating, chromate processing, and silane coupling processing are performed is used as it is. "The blackening processing" indicates the case where common copper foil for which processings such as zinc plating, chromate processing, and silane coupling processing are performed as the copper foil 202 is processed by soft etching to remove a layer processed, and then blackening processing is performed. Reduction processing after that is called "blackening reduction processing".

As is apparent from this drawing, it is preferable that at least blackening reduction processing is performed for the copper foil 202 before lamination on the metal plate 1a. With respect to the soft etching, the electrical conductivity is good but the roughness of the surface of copper foil obtained is insufficient. Thus, it is not practical in view of the resulting inferior adhesive property thereof to the resin.

Note that, it can be said that performing blackening reduction processing also for the upper surfaces of the bumps 2a of the metal plate 1a is even more preferable in reducing a contact resistance. In addition, it can be said that blackening reduction processing is even more preferable in improving the connection between the bumps 2a and the copper foil 202.

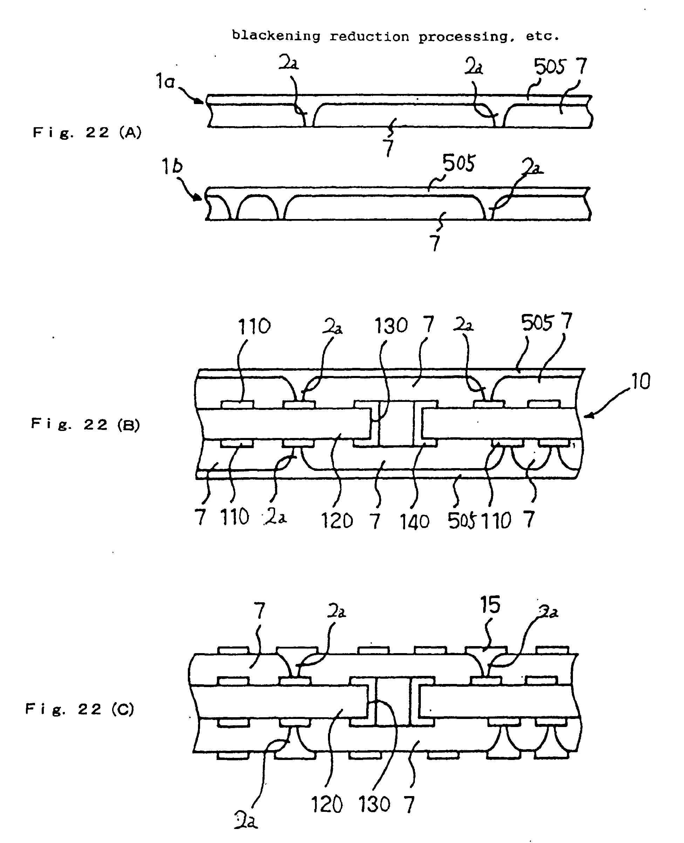

Figs. 22(A) to 22(C) are sectional views showing an eleventh embodiment mode of a multi-layer wiring board manufacturing method according to the present invention in step order. In this embodiment, the multi-layer wiring board manufacturing method is as follows. Respective metal plates 1a and 1b in which an insulating layer is formed in a portion between respective bumps on bump forming side surfaces of copper foil in which the bumps are selectively formed (see Fig. 22 (A)) are laminated on both surfaces of a wiring board 10 in which wiring films are formed on both surfaces of an insulating plate and the wiring films on both surfaces of the insulating plates are electrically connected with each other through a through hole (see Fig. 22(B)). Further, the copper foils of the metal plates 1a and 1b are patterned to form wiring films.

(A) As shown in Fig. 22(A), the metal plates 1a and 1b in which the formation of bumps 2a by selective etching of copper foils 505 and the formation of an interlayer insulating layer 7 by lamination of an insulating sheet are completed are prepared, and blackening reduction processing is performed for the surfaces of at least the bumps 2a.

The processing can be performed as in the case of the embodiment mode as shown in Fig. 21.

Note that 505 denotes copper foils composing bases of the metal plate 1a and 1b, which are patterned by selective etching later to become wiring films. 2a denotes bumps formed by selective half etching of the copper foils 505 (half etching is an etching in which the etching thickness is thinner than the thickness of the copper foil 505, and not necessarily limited to a thickness of 1/2). In this example, the metal plate 1a and 1b in which no etching barrier layers (see the portion indicated by reference numeral 4 in Fig. 10(A)) are located are used. However, in this embodiment mode, the metal plate 1a having an etching barrier layer 402 as shown in Fig. 20(A) may be used.

(B) Next, as shown in Fig. 22 (B) , the above metal plates 1a and 1b are positioned on both surfaces of the wiring board 10 such that the respective bumps 2a are matched to corresponding wiring films 110 made of copper, which are located on both surfaces of the wiring board 10 and for which roughness processing, preferably, blackening reduction processing is performed, laminated thereon, pressurized, and integrally formed. The lamination and the integral formation prevent oxidization, and the above blackening reduction processing allows a more preferable pressure welding state between the copper wiring films 110 and the copper bumps 2a. Alternatively, it is preferably conducted as soon as possible immediately after the blackening processing and subsequent reduction processing. Note that 120 denotes an insulating plate composing a base of the wiring board 10, 130 denotes a through hole which penetrates the insulating plate 120, and 140 denotes a through hole wiring film which is formed on the surface of the through hole 130 to provide interconnection between upper and lower wirings.

(C) After that, as shown in Fig. 22 (C) , the copper foils 505 of the above metal plates 1a and 1b are selectively etched to form wiring films 15.

According to this embodiment mode, since, after oxides on the upper surfaces of the bumps 2a of the metal plates 1a and 1b are removed, and, needle shaped crystallization blackening processing for obtaining roughness and reduction processing for reducing the oxides produced by the blackening processing are performed to improve the connection, the metal plates 1a and 1b can be laminated on both surfaces of the wiring board 10, an electrical resistance between the bumps 2a and the wiring films 110 can be reduced.

Also, with respect to the wiring board 10, as well as in the case of the metal plates 1a and 1b, it is preferable that blackening reduction processing is performed for the wiring films 110 which are located on both surfaces and made of copper. Thus, a contact resistance between the bumps 2a and the wiring films 110 can be further reduced and the connection property can be further improved.

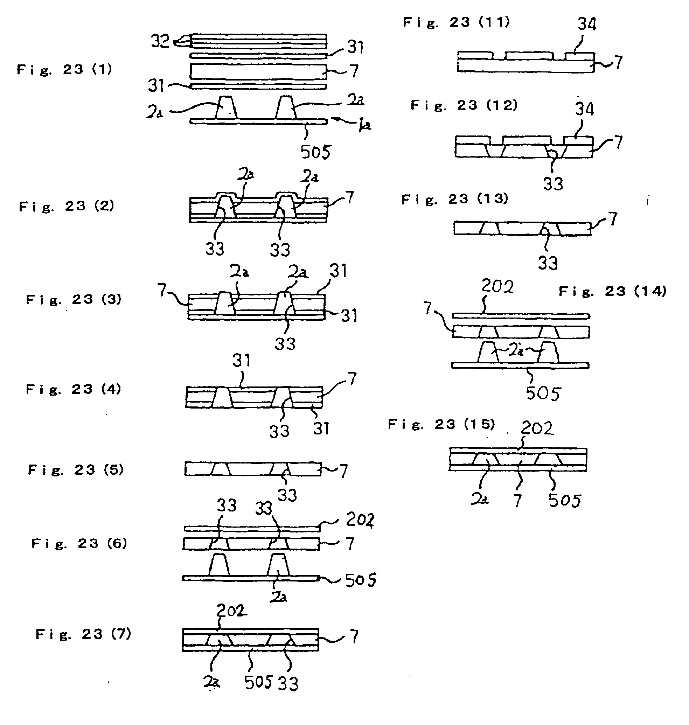

Figs. 23(1) to 23(7) are sectional views showing a twelfth embodiment mode of a multi-layer wiring board manufacturing method according to the present invention in step order and Figs. 23(11) to 23(15) are sectional views showing a modified example of the twelfth embodiment mode in step order.

First, the twelfth embodiment mode will be described with reference to Figs. 23(1) to 23(7). In this embodiment, in order not to deposit a polishing powder on a product, an interlayer insulating layer 7 is formed in a region in which the bumps 2a are not formed, of a metal plate 1a in which the bumps 2a are formed on the surface of copper foil 505

In other words, the present applicant has developed as an interlayer insulating layer forming method a method of laminating a sheet interlayer insulating layer 7 in a bump forming surface side of the metal plate 1a with a state in which a peeling film is overlapped therewith so that the sheet interlayer insulating layer 7 is penetrated by the bumps 2a. However, with respect to this method, when the lamination is conducted and then polishing is conducted for the bump forming surface side of the metal plate 1a to expose the surfaces of the bumps 2a, there is a possibility that a polished powder is produced from a release film, copper, and the like and deposited onto a product. The twelfth embodiment mode is intended to eliminate such a defect.

(1) As shown in Fig. 23(1), a laminate of a release film 31, the sheet interlayer insulating layer 7, a release film 31, and slit sheets 32 consisting of for example three overlapped sheets is provided to the bump forming surface side of the metal plate 1a in which the bumps 2a are formed on one surface of the copper foil 505.

(2) Next, the laminate of the release film 31, the sheet interlayer insulating layer 7, the release film 31, and the slit sheets consisting of for example three overlapped sheets 32, 32, and 32 is laminated on the bump forming surface of the metal plate 1a so that a state in which the lowermost release film 31 and the interlayer insulating layer 7 are penetrated by the bumps 2a is obtained. After that, for example the slit sheets consisting of for example three overlapped sheets 32 are removed. Fig. 23(2) shows a state after the removal of the slit sheets 32. In this step, respective bump holes 33 which are engaged with the respective bumps 2a are formed in the interlayer insulating layer 7.

(3) After that, the bump forming surface of the metal plate 1a is polished to expose the upper portions of the respective bumps 2a as shown in Fig. 23(3).

(4) Next, as shown in Fig. 23(4), the three-layer structure portion composed of the release film 31, the interlayer insulating layer 7, the release film 31 is separated from the metal plate 1a. It is needless to say that the bump holes 33 which are engaged with the respective bumps 2a and penetrated thereby are formed corresponding to them in the three-layer structure portion.

(5) Next, from the three-layer structure body composed of the release film 31, the interlayer insulating layer 7, the release film 31, the release films 31 and 31 located to both surfaces thereof are removed. Thus, as shown in Fig. 23(5), the interlayer insulating layer 7 in which the bump holes 33 are formed is left.

(6) Next, as shown in Fig. 23(6), the above interlayer insulating layer 7 is positioned on the bump forming surface of the above metal plate 1a such that the respective bump holes 33 correspond to the respective bumps 2a, and faces them. In addition, a copper layer 202 for wiring film formation faces the interlayer insulating layer 7 from above.

(7) Next, as shown in Fig. 23(7), the above interlayer insulating layer 7 and the above copper layer 202 are pressurized to the above metal plate 1a and integrally formed. The multi-layer wiring board manufacturing method shown in Figs. 23(1) to 23(7) corresponds to an embodiment mode of the present invention of claim 27.

According to the embodiment mode, the formation of the interlayer insulating layer 7 to a portion in which the bumps 2a are not formed on the copper foil 505 of the metal plate 1a is as follows. A layer having the bump holes 33 to be engaged with the respective bumps in portions corresponding to the respective bumps 2a is prepared as the interlayer insulating layer 7. The interlayer insulating layer 7 is overlapped on the above copper foil 505 by engaging the above respective bump holes 33 with the bumps 2a corresponding thereto. Further, the copper layer 202 for wiring film formation on the above interlayer insulating layer is heated and pressurized. Thus, there is no possibility that a polished powder is produced and deposited onto a product in the case where polishing is conducted to expose the bumps with a state in which for example a release film is overlapped and then lamination is conducted.

Figs. 23(11) to 23(15) are sectional views showing a modified example of the embodiment mode shown in Figs. 23(1) to 23(7) in step order.

According to this modified example, the bump holes 33 in the interlayer insulating layer 7 are formed by performing selective etching processing for the interlayer insulating layer 7, and only a method of forming the bump holes 33 is different from the embodiment mode in which the bump holes 33 are formed in a manner of a transfer method and shown in Figs. 23 (1) to 23 (7) .

Hereinafter, the modified example will be described in step order with reference to Figs. 23(11) to 23(15).

(11) First, the interlayer insulating layer 7 is prepared and a mask form 34 is put on the surface thereof. The mask form 34 has openings 35 in locations corresponding to the bumps 2a of the metal plate 1a. The mask form 34 can be formed by a method of preparing a plate body made of metal or the like, such as for example stainless steel and patterning it by photo etching (formation, exposure, and development of a photo resist film). Fig. 23(11) shows a state in which the mask form 34 is put on the interlayer insulating layer 7.

(12) Next, as shown in Fig. 23(12), the above form 34 is used as a master form and the sheet interlayer insulating layer 7 is selectively irradiated with laser light to form the bump holes 33 in the interlayer insulating layer 7.

(13) After that, the mask form 34 is removed, and as shown in Fig. 23(13), the interlayer insulating layer 7 in which the bump holes 33 are formed is completed.

(14) Next, as shown in Fig. 23(14), the above interlayer insulating layer 7 is positioned on the bump forming surface of the above metal plate 1a such that the respective bump holes 33 correspond to the respective bumps 2a, and faces them. In addition, the copper layer 202 for wiring film formation faces the interlayer insulating layer 7 from above.

(15) Next, as shown in Fig. 23(15), the above interlayer insulating layer 7 and the above copper layer 202 are pressurized to the above metal plate 1a and integrally formed. The multi-layer wiring board manufacturing method shown in Figs. 23(11) to 23(15) corresponds to an embodiment mode of the present invention in claim 28.

Even in such a modified example, the same effect as the embodiment mode shown in Figs. 23(1) to 23(7) can be obtained.

Note that the formation of the bump holes 33 into the interlayer insulating layer 7 or the formation of the interlayer insulating layer 7 having the bump holes 33 is not necessarily limited to the above example. The bump holes 33 may be formed by a drill or laser. In addition, various variations may be taken in this respect, such as putting a roller, which has on its surface protrusions corresponding to portions in which the bump holes are to be formed, onto the interlayer insulating layer 7 and rotating it so that the portions corresponding to the protrusions are dropped to form the bumps 33, or forming the interlayer insulating layer 7 having the bump holes 33 by printing.

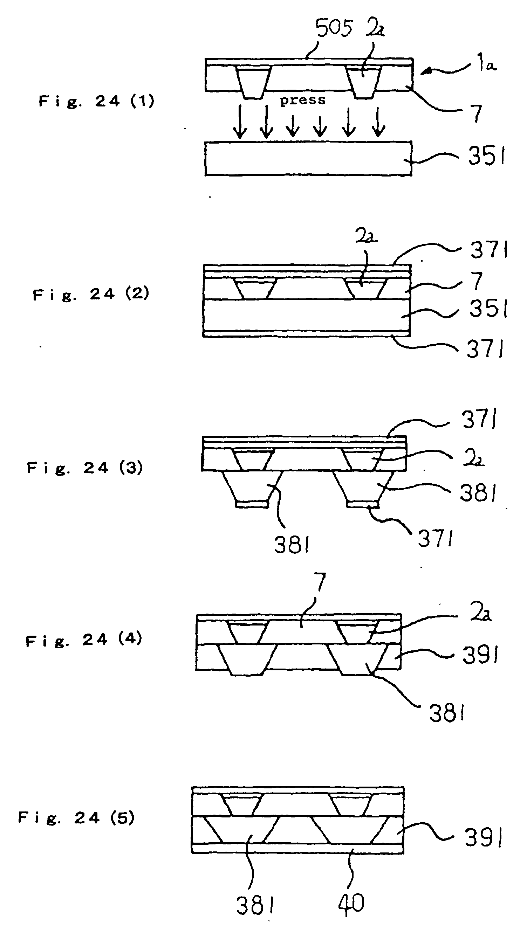

Figs. 24(1) to 24(5) are sectional views showing a thirteenth embodiment mode of a multi-layer wiring board manufacturing method according to the present invention in step order. This embodiment mode is made such that the height of the bump can be increased. The height of the bump of the multi-layer wiring board is for example about 100 µm in many cases. There is also a case where it is necessary to increase the height of a bump 2a. However, it is difficult to respond to this requirement by a conventional technique. This is because, in order to increase the height of the bump, it is necessary as a matter of course to increase an etching depth at the time of selective etching for forming the bump, and the amount of side etching increases with increasing the etching depth, which hinders formation of fine pattern. Thus, in this embodiment mode, the height of the bump is increased without hindering such fine pattern formation.

Hereinafter, the thirteenth embodiment mode will be described in step order with reference to Figs. 24(1) to 24(5).

(1) First, as shown in Fig. 24(1), a metal plate 1a in which the bumps 2a are formed on a copper layer 505 and an interlayer insulating layer 7 is formed in a portion in which the bumps 2a are not formed, and an extension bump forming copper plate (for example 100 µm in thickness) 351 are prepared, and the metal plate 1a is laminated on one main surface of the copper plate 351 by pressurizing with a state in which a bump 2a forming side surface faces the one main surface of the copper plate 351.

(2) Next, as shown in Fig. 24(2), photo resist films 371 are formed on both main surfaces of a laminate body of the metal plate 1a and the copper plate 351. The photo resist films 371 are used as etching masks for forming extension bumps (381) from the copper plate 351. Note that the extension bumps (381) are formed so as to position them in locations corresponding to the respective bumps 2a of the above metal board 1a.

(3) Next, as shown in Fig. 24(3), the photo resist films 371 are patterned by exposure and development, the copper plate 351 is selectively etched using the patterned photo resist films 371 as masks to form the extension bumps 381 whose bottoms are in contact with the top portions of the respective bumps 2a of the metal plate 1a.

(4) Next, as shown in Fig. 24(4), an interlayer insulating layer 391 for insulating between the respective adjacent extension bumps 381 and layers is formed in a portion in which the extension bumps 381 from the copper plate 351 are not formed. The interlayer insulating layer 391 can be formed by the same method as for example a method of forming the interlayer insulating layer 7 which is previously described and shown in Fig. 23 or may be formed by another method.

(5) After that, as shown in Fig. 24(5), a copper layer 401 for wiring formation is laminated on the surface of the interlayer insulating layer 391 and the surfaces of the extension bumps 381 by pressurizing.

According to such a method, the practical height of the bump becomes the sum of the height of the bump 2a and the height of the extension bump 381 and thus becomes large. Therefore, the bumps that are larger in height than a conventional ones can be formed.

Note that a series of steps in which the copper layer 351 is laminated, selective etching is conducted for the copper layer 351 to form the extension bumps 381, and the interlayer insulating layer 391 is formed are repeated plural times. Thus, the amount of extension of the bump height by the extension bumps 381 can be also increased stepwise.

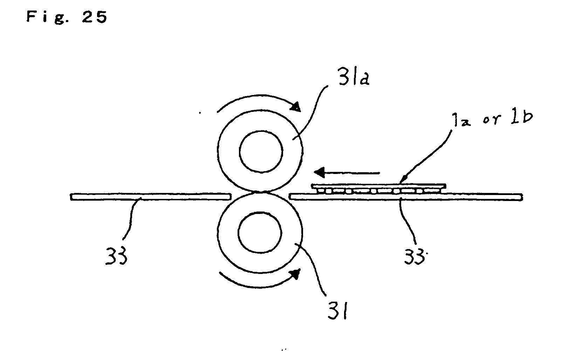

Fig. 25 is a sectional view showing a fourteenth embodiment mode of a multi-layer wiring board manufacturing method according to the present invention. In this embodiment mode, before another member (for example, copper foil 202 or a wiring board 10) is laminated, a metal plate 1a in which the formation of bumps by selective etching of copper foil and the formation of an insulating layer 7 by lamination of insulating sheets are completed is passed between rollers 31 and 31a, and processing for polishing the surfaces of the bumps is conducted therefor.

The roller 31 is a press roller, the roller 31a is a polishing roller made of for example ceramics, and 33 denotes a carrying conveyor. The metal plate 1a is placed on the carrying conveyor 33 such that a bump forming side surface is in contact with the carrying conveyor 33, and passed between the rollers 31 and 31a to conduct polishing.

Thus, after that, it is confirmed that a contact resistance between the bump 2a obtained by laminating the metal plate 1a and another member (for example, the copper foil 202 or the wiring board 10) and the copper foil 202 or wiring films 110 on both surfaces of the wiring board 10 can be reduced and the connection therebetween can be improved.

Then, it is also confirmed that the reason why the contact resistance can be reduced and the connection can be improved is that contamination of the surfaces of the bumps 2a by a resin and the like is removed.

In other words, when an insulating sheet is laminated on the metal plate 1a in which the formation of the bumps 2a is completed to form an interlayer insulating layer 7, a portion of a resin composing the insulating layer 7 and another foreign matter are deposited onto the bump surfaces so that the bump surface is contaminated. When the lamination is conducted without removing the contamination, the contact resistance between the bump and another member (for example, the copper foil 202 or the wiring board 10) slightly increases due to the contamination and percentage defective becomes higher.

Therefore, as shown in Fig. 25, when polishing processing is performed such that the metal plate 1a in which the formations of the bumps and the interlayer insulating layer are completed is passed between the rollers 31 and 31a, a resin on the upper surfaces of the bumps or a foreign matter by glass cloth and the like is removed thereby. Accordingly, the contact resistance between the bump 2a and the copper foil 202 or the wiring films 110 on both surfaces of the wiring board 10 can be reduced and the connection therebetween can be improved.

### INDUSTRIAL APPLICABILITY

In order to obtain a multi-layer wiring board with high integration, instead of using a conventional technique in which holes are formed in the insulating board composing a base, the metal plating film for interconnecting upper and lower wirings is formed on the inner peripheral surface thereof, and the holes are buried, interconnection between upper and lower wirings is provided by using minute bumps such that wiring boards can be laminated in succession at high integration. In addition, in order to reduce an electrical resistance value between a metal surface on which the bumps are formed and a metal surface which is connected therewith, Vickers hardness is set to 80 to 150 Hv. Further, both metal surfaces are mechanically polished to keep electrical connection between those contact surfaces. Thus, a problem such as contact failure between them is also solved and stability is realized in the multi-layering of the wiring boards. Accordingly, miniaturization of the wiring board for an electronic device can be anticipated.

## Claims

1. A method of manufacturing a multi-layer wiring board, **characterized by** comprising at least a lamination step of
preparing a plurality of multi-layer metal plates in each of which a wiring film forming metal layer or a wiring film is formed on a bump forming metal layer through an etching stop layer,
patterning a bump forming metal layer of a first multi-layer metal plate to form a bump,
forming an insulating layer on a surface for forming the bump so as to expose only a top portion of the bump from the insulating layer,
then, laminating a second multi-layer metal plate on the bump of the first multi-layer metal plate in a state where a wiring layer forming surface of the second multi-layer plate faces the first multi-layer plate,
then, forming a bump on a bump forming surface of the second multi-layer metal plate and forming an insulating layer thereon so as to expose only a top portion of the bump from the insulating layer, and
then, laminating a third multi-layer metal plate by connecting a wiring film of the third multi-layer metal plate with the bump of the second multi-layer metal plate.

2. A method of manufacturing a multi-layer wiring board according to claim 1, **characterized in that**
after all the laminations are completed, selective etching is conducted for a bump forming metal layer of the last laminated multi-layer metal plate to form a bump,
an insulating layer is formed on the bump forming surface of the last multi-layer metal plate so as to expose only a top portion of the bump from the insulating layer,
then a wiring film forming metal thin plate is laminated on the insulating layer in a state that it is connected with the bump, and
a wiring film is formed by patterning the wiring film forming metal thin plate or by patterning the wiring film forming metal thin plate and a wiring film forming metal layer of the one multi-layer metal plate.

3. A method of manufacturing a multi-layer wiring board, **characterized by** comprising at least a lamination step of:
forming a wiring film on a bump forming metal layer through an etching stop layer;
patterning the bump forming metal layer and the etching stop layer to form a bump;
preparing a plurality of multi-layer metal plates in each of which an insulating layer is formed on a bump forming surface thereof so as to expose only a top portion of the bump from the insulating layer;
of the multi-layer metal plates, connecting the bump of a second multi-layer metal plate with the wiring film of another multi-layer metal plate to laminate the two multi-layer metal plates; and
connecting the bump of another multi-layer metal plate with the wiring film of a third multi-layer metal plate to further laminate a multi-layer metal plate on the multi-layer metal plate laminate body.

4. A method of manufacturing a multi-layer wiring board according to claim 3, **characterized in that**
after all the laminations are completed, a wiring film forming metal thin plate is laminated on the insulating layer of the last laminated multi-layer metal plate in a state where it is connected with the bump, and
a wiring film is formed by patterning the wiring film forming metal thin plate or by patterning the wiring film forming metal thin plate and a wiring film forming metal layer of the one multi-layer metal plate.

5. A method of manufacturing a multi-layer wiring board, **characterized by** comprising at least a lamination step of
preparing a multi-layer metal plate in which a wiring film is formed on a bump forming metal layer through an etching stop layer,
forming a bump forming metal layer on the entirety of a surface of the multi-layer metal plate on which the wiring film is formed, through at least the etching stop layer,
patterning the bump forming metal layer in which the bump forming metal layer is laminated through the etching stop layer, and the etching stop layer to form a bump,
forming an insulating layer on a surface on which the bump is formed so as to expose only a top portion of the bump from the insulating layer,
then, forming a wiring film or a wiring board having a wiring film, on a surface where the bump protrudes,
patterning a bump forming metal layer, which is formed on the entirety of a surface of the multi-layer metal plate on which the wiring film is formed through at least an etching stop layer, and the etching stop layer, to form a bump,
forming an insulating layer on a surface for forming the bump so as to expose only a top portion of the bump from the insulating layer, and
then, forming a wiring film or a wiring board having a wiring film, on a surface where the bump protrudes.

6. A method of manufacturing a multi-layer wiring board according to claim 1, 2, 3, 4, or 5, **characterized in that** the wiring film of the multi-layer metal plate in which the wiring film is formed on the bump forming metal layer through the etching stop layer is formed by using as a base a bump forming metal layer on which a wiring film forming metal layer is formed through the etching stop layer and patterning the wiring film forming metal layer.

7. A method of manufacturing a multi-layer wiring board according to claim 1, 2, 3, 4, or 5, **characterized in that** the wiring film of the multi-layer metal plate in which the wiring film is formed on the bump forming metal layer through the etching stop layer is formed by using as a base a bump forming metal layer on which the etching stop layer is formed and selectively conducting wiring forming metal plating for an anti-bump forming metal layer side surface of the etching stop layer.

8. A method of manufacturing a multi-layer wiring board, **characterized by** comprising:
preparing a plural kinds of basic wiring boards with a multi-layer wiring structure in each of which a wiring film is formed on at least one surface of a multi-layer metal plate, a wiring film or a wiring film forming metal plate is formed on the other surface, interlayer insulation is provided by an insulating film, and interlayer connection is provided by a bump made of metal; and
laminating a plurality of basic wiring boards including different kinds of boards from among the plural kinds of basic wiring boards.

9. A method of manufacturing a multi-layer wiring board according to claim 8, **characterized in that**
boards in each of which a wiring film is formed on one surface and a wiring film forming metal layer is formed on the other surface are selected as the uppermost board and the lowermost board, from among the plurality of basic wiring boards to be laminated,
the plurality of basic wiring boards are laminated such that respective wiring film forming metal layers of the uppermost board and the lowermost board of the plurality of the basic wiring boards to be laminated face toward the outside, and
then, the wiring film forming metal layers of the uppermost and lowermost basic wiring boards are simultaneously patterned to form wiring films of the uppermost layer and the lowermost layer.

10. A method of manufacturing a multi-layer wiring board, **characterized by** comprising:
a step of forming a reinforcing layer on one surface of a multi-layer metal plate for forming a wiring board;
a step of laminating another member on a surface of the multi-layer metal plate which is opposite to the reinforcing layer; and
then, a step of at least peeling the reinforcing layer.

11. A method of manufacturing a multi-layer wiring board, **characterized by** comprising:
a step of forming a reinforcing layer on one surface of a multi-layer metal plate for forming a wiring board;
a step of conducting patterning and lamination of another member with respect to a surface of the multi-layer metal plate which is opposite to the reinforcing layer; and
then, a step of at least peeling the reinforcing layer.

12. A method of manufacturing a multi-layer wiring board according to claim 10 or 11, **characterized in that** the reinforcing layer is made from a heat resistant film to which a peeling layer is provided.

13. A method of manufacturing a multi-layer wiring board according to claim 12, **characterized in that** the heat resistant film is made of a polyphenylene sulfide resin, a polyetherimide resin, a liquid crystal polymer film, or a polyether etherketone resin.

14. A metal board for forming a wiring board, which has a three-layer structure and in which a metal bump for interlayer connection is formed on one surface, **characterized in that**
a peeling layer and a heat resistant film are laminated in advance on a surface which is opposite to the one surface and which later becomes a wiring film.

15. A method of manufacturing a multi-layer wiring board in which, on one main surface of a multi-layer metal plate in which a plurality of metal bumps each having a longitudinal cross sectional shape such as a cone shape or a trapezoid shape are arranged in predetermined positions on the one main surface, at least an insulating layer which is made of a synthetic resin and composed of an interlayer insulating film having a thickness smaller than the height of the bumps is covered so as to follow the shapes of the respective metal bumps, and the one main surface of the metal plate is polished so that a portion of the insulating layer which covers the bumps is removed to expose upper surfaces of the bumps, **characterized in that**
the polishing is conducted by placing the metal plate such that the one main surface faces upward, moving a cutter having a large width relatively to the metal plate in parallel to the main surface to thereby cut the top surfaces of the respective bumps with the cutter such that they lie on the same plane as the surface of the insulating layer.

16. A method of manufacturing a multi-layer wiring board according to claim 15, **characterized in that** the cutter having a large width is moved in a direction parallel to the metal plate while applying low frequency vibration or ultrasonic vibration in a direction perpendicular to the main surface.

17. A polishing machine for a multi-layer wiring board, **characterized by** comprising:
a metal plate holding means for holding a metal plate, in which a plurality of bumps each having a longitudinal cross sectional shape such as a cone shape or a trapezoid shape are arranged in predetermined positions of its one main surface and at least an insulating layer which is made of a synthetic resin and composed of an interlayer insulating film having a thickness smaller than the thickness of the bumps is covered on the one main surface so as to follow the shapes of the respective bumps, in a state that the one main surface faces upward;
a cutter holding means for holding a cutter having a large width above the metal plate;
a height adjustment mechanism for adjusting the height of the cutter holding means relative to the metal plate; and
a cutter parallel moving mechanism for relatively moving the cutter holding means in parallel to the surface of the metal plate.

18. A method of manufacturing a multi-layer wiring board in which, on one main surface of a metal plate in which a plurality of bumps each having a longitudinal cross sectional shape such as a cone shape or a trapezoid shape are arranged in predetermined positions on the one main surfaces, at least an insulating layer which is made of a synthetic resin and composed of an interlayer insulating film having a thickness smaller than the thickness of the bumps is covered so as to follow the shapes of the respective metal bumps, and in which the one surface of the metal plate is polished so that a portion of the insulating layer which covers the bumps is removed so as to expose upper surfaces of the bumps, **characterized in that**
the polishing is conducted by passing the metal plate for pressing between a polishing roller in which a polishing material is sintered on its peripheral surface and a backup roller such that the one main surface comes into contact with the polishing roller, and cutting the top surfaces of the respective bumps with the polishing roller such that they lie on the same plane as the surface of the insulating layer.

19. A method of manufacturing a multi-layer wiring board according to claim 18, **characterized in that** polishing conducted by passing a multi-layer metal plate between a polishing roller and a backup roller is conducted plural times such that the degree of finish is gradually increased.

20. A polishing machine for a multi-layer wiring board, **characterized by** comprising:
a polishing roller in which a polishing material is sintered on its peripheral surface;
a roller rotating means for rotating the polishing roller;
a backup roller;
a means for pressing the backup roller onto the polishing roller;
and a carrying means for carrying a metal plate between the polishing roller and the backup roller.

21. A polishing machine for a multi-layer wiring board which comprises a plurality of metal plate polishing portions each including at least: a polishing roller in which a polishing material is sintered on its peripheral surface; a roller rotating means for rotating the polishing roller; a backup roller; a pressing means for pressing the backup roller onto the polishing roller; and a carrying means for carrying a metal plate between the polishing roller and the backup roller, **characterized in that** the roughnesses of the polishing materials of the polishing rollers in the respective metal plate polishing portions are made different from each other.

22. A method of manufacturing a multi-layer wiring board in which, on one main surface of a multi-layer metal plate in which a plurality of metal bumps each having a longitudinal cross sectional shape such as a cone shape or a trapezoid shape are arranged in predetermined positions of the one main surface, at least an insulating layer which is made of a synthetic resin and composed of an interlayer insulating film having a thickness smaller than the thickness of the bumps is covered so as to follow the shapes of the respective metal bumps, and in which the one main surface of the metal plate is polished so that a portion of the insulating layer which covers the bumps is removed to expose upper surfaces of the bumps, **characterized in that**
the polishing is conducted by rotating a cutter roller in which cutters each having a large width are provided on its peripheral surface such that cutting edges thereof protrude toward a rotational direction side and are rotated, and moving the cutter roller in parallel to the surface of the metal plate while cutting the top surfaces of the respective bumps with the wide cutters of the rotated cutter roller such that they lie on the same plane as the surface of the insulating layer.

23. A polishing machine for a multi-layer wiring board, **characterized by** comprising:
a metal plate holding means for holding a metal plate, in which a plurality of bumps each having a longitudinal cross sectional shape such as a cone shape or a trapezoid shape are arranged in predetermined positions of its one main surface and at least an insulating layer that is made of a synthetic resin and composed of an interlayer insulating film having a thickness smaller than the thickness of the bumps is covered on the one main surface so as to follow the shapes of the respective metal bumps, in a state where the one main surface faces upward;
a cutter roller holding means for rotatably holding, above the metal plate, a cutter roller in which cutters each having a large width are provided on its peripheral surface such that cutting edges thereof protrude toward a rotation direction side;
a rotation drive means for rotating the cutter roller;
a height adjustment mechanism for adjusting the height of the cutter roller holding means relative to the multi-layer metal plate; and
a cutter roller parallel moving mechanism for relatively moving the cutter roller holding means in parallel to the surface of the metal plate.

24. A multi-layer wiring film forming board in which, on an interlayer insulating layer and a top surface of a bump of one wiring film forming board in which the bump for interconnecting upper and lower wirings and made of metal is integrally formed on a metal layer and the interlayer insulating film is formed in a portion in which the bump is not formed on the metal layer, a metal layer or another wiring film forming board is laminated, **characterized in that** Vickers hardnesses of the metal layer and the bump are set to 80 to 150 Hv.

25. A method of manufacturing a multi-layer wiring board in which, on an interlayer insulating layer and a top surface of a bump of one wiring film forming board in which the bump for interconnecting upper and lower wirings and made of metal is integrally formed on a metal layer and the interlayer insulating film is formed in a portion in which the bump is not formed on the metal layer, a metal plate or another wiring film forming board is laminated to electrically connect the bump with the metal plate or a wiring film of another wiring film forming board which is made of metal to thereby manufacture a multi-layer wiring board, **characterized in that**
before the lamination, blackening reduction processing is performed for one or both of: a top surface of a bump of the one wiring film forming board; a surface of the metal plate or the wiring film of another wiring film forming board which is made of metal.

26. A method of manufacturing a multi-layer wiring board in which, on an interlayer insulating layer and a top surface of a bump of one wiring film forming board in which the bump for interconnecting upper and lower wirings and made of metal is integrally formed on a metal layer and the interlayer insulating film is formed in a portion in which the bump is not formed on the metal layer, a metal layer or another wiring film forming board is laminated, **characterized in that**
in the one wiring circuit forming board in which upper and lower wirings interconnecting bumps made of metal are integrally formed on a metal layer, the formation of the interlayer insulating layer in a portion of the metal layer in which the bumps are not formed is performed by:
preparing an interlayer insulating layer in which bump holes for engaging with the respective bumps are formed in a portion corresponding to the upper and lower wirings interconnecting bumps;
overlapping the interlayer insulating film on the metal layer in a state that the respective bump holes thereof are engaged with the corresponding respective upper and lower wirings interconnecting bumps; and
pressurizing a wiring forming metal layer onto the interlayer insulating film.

27. A method of manufacturing a multi-layer wiring board according to claim 26, **characterized in that**
the formation of the bump holes in the interlayer insulating layer is performed by bringing the interlayer insulating layer into contact with a bump forming surface of a wiring film forming board in which upper and lower wirings interconnecting bumps are formed so that the interlayer insulating layer is penetrated by the upper and lower wirings interconnecting bumps.

28. A method of manufacturing a multi-layer wiring board according to claim 26, **characterized in that**
the formation of the bump holes in the interlayer insulating layer is performed by selectively penetrating the interlayer insulating layer by laser light irradiation using as a mask a mask body having substantially the same pattern as the upper and lower wirings interconnecting bumps of the wiring film forming board.

29. A multi-layer wiring board **characterized in that**:
on an interlayer insulating layer and upper surfaces of bumps of a board in which the upper and lower wirings interconnecting bumps made of metal are integrally formed on a metal layer and the interlayer insulating layer is formed in a portion in which the bumps are not formed on the metal layer, a metal plate in which extension bumps are formed in positions corresponding to the respective upper and lower wirings interconnecting bumps is laminated such that the respective bumps are electrically connected with the respective upper and lower wirings interconnecting bumps corresponding thereto; and
an interlayer insulating layer is formed in a portion of the metal plate in which the extension bumps are not formed.

30. A method of manufacturing a multi-layer wiring board, **characterized by** comprising:
a step of laminating a metal plate on an interlayer insulating layer and upper surfaces of upper and lower wirings interconnecting bumps of a board in which the upper and lower wirings interconnecting bumps made of metal are integrally formed on a metal layer and the interlayer insulating layer is formed in a portion in which the bumps are not formed on the metal layer;
a step of selectively etching the metal plate to form extension bumps connected with the respective upper and lower wirings interconnecting bumps in positions corresponding thereto; and
a step of forming an interlayer insulating layer in a portion of the metal plate in which the extension bumps are not formed.

31. A method of manufacturing a multi-layer wiring board in which a metal layer or another wiring circuit forming board is laminated on an interlayer insulating layer and upper surfaces of bumps of a wiring film forming board in which the upper and lower wirings interconnecting bumps made of metal are integrally formed on a metal layer and the interlayer insulating layer is formed in a portion in which the bumps are not formed on the metal layer, **characterized by** comprising
polishing the wiring film forming board, in which the interlayer insulating layer is formed by laminating an insulating layer composing the interlayer insulating layer on a surface of the metal layer on which the upper and lower wirings interconnecting bumps are formed, by passing it between the polishing roller and the backup roller before the metal layer or another wiring circuit forming board is laminated.
